(19) Europäisches Patentamt
European Patent Office
Office européen des brevets

(11) EP 3 852 158 B1

# (12) EUROPEAN PATENT SPECIFICATION

(45) Date of publication and mention of the grant of the patent:
**01.11.2023 Bulletin 2023/44**

(21) Application number: **19860837.4**

(22) Date of filing: **10.09.2019**

(51) International Patent Classification (IPC):
***H10N 10/817*** *(2023.01)* ***H10N 10/17*** *(2023.01)*

(52) Cooperative Patent Classification (CPC):
**H10N 10/817; H10N 10/17;** H10N 10/852

(86) International application number:
**PCT/KR2019/011727**

(87) International publication number:
**WO 2020/055101 (19.03.2020 Gazette 2020/12)**

## (54) THERMOELECTRIC ELEMENT

THERMOELEKTRISCHES ELEMENT

ÉLÉMENT THERMOÉLECTRIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **11.09.2018 KR 20180108436**

(43) Date of publication of application:
**21.07.2021 Bulletin 2021/29**

(60) Divisional application:
**23189572.3 / 4 258 848**

(73) Proprietor: **LG Innotek Co., Ltd.**
**Seoul 07796 (KR)**

(72) Inventor: **PARK, Jin Gyeong**
**07796 Seoul (KR)**

(74) Representative: **M. Zardi & Co S.A.**
**Via G. B. Pioda, 6**
**6900 Lugano (CH)**

(56) References cited:
**JP-A- 2000 349 352**
**JP-A- 2004 303 872**
**KR-A- 20130 035 016**
**KR-A- 20160 126 804**
**KR-A- 20160 126 804**
**KR-A- 20160 126 805**
**KR-A- 20160 126 805**
**KR-A- 20180 010 060**
**US-A1- 2010 096 357**
**US-A1- 2010 096 357**
**US-A1- 2013 081 663**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).



Processed by Luminess, 75001 PARIS (FR)

## Description

[Technical Field]

The present invention relates to a thermoelectric element, and more specifically, to an electrode of a thermoelectric element.

[Background Art]

A thermoelectric phenomenon is a phenomenon which occurs due to movement of electrons and holes in a material and refers to direct energy conversion between heat and electricity.

A thermoelectric element is a generic term for a device using the thermoelectric phenomenon and has a structure in which a P-type thermoelectric material and an N-type thermoelectric material are joined between metal electrodes to form a PN junction pair.

Thermoelectric elements can be classified into a device using temperature changes of electrical resistance, a device using the Seebeck effect, which is a phenomenon in which an electromotive force is generated due to a temperature difference, a device using the Peltier effect, which is a phenomenon in which heat absorption or heat generation by current occurs, and the like. The thermoelectric element is variously applied to home appliances, electronic components, communication components, or the like. For example, the thermoelectric element can be applied to a cooling device, a heating device, a power generation device, or the like. Accordingly, the demand for thermoelectric performance of the thermoelectric element is increasing more and more.

The thermoelectric element includes substrates, electrodes, and thermoelectric legs, wherein a plurality of thermoelectric legs are arranged in an array form between an upper substrate and a lower substrate, a plurality of upper electrodes are arranged between the plurality of thermoelectric legs and the upper substrate, and a plurality of lower electrodes are arranged between the plurality of thermoelectric legs and the lower substrate.

Generally, a plurality of electrodes can be aligned on a jig and then bonded to the substrates. In this case, in order to align the plurality of electrodes on the jig and bond the plurality of electrodes to the substrates, since a predetermined time and process are required, a process of transferring and removing a silicon tape is also required, and the jig should be manufactured for each size or design of the thermoelectric element, this can become a factor which increases process costs. Further, when the plurality of electrodes are bonded to the substrates, a pressure applied to the plurality of electrodes may not be uniform, and accordingly, some of a material bonding between the plurality of electrodes and the substrates can go over to the plurality of electrodes. When foreign matter is present even in portions of the plurality of electrodes, electrical conductivity of the thermoelectric element can be affected. Further, since bonding strength between the plurality of electrodes and the substrates is not uniform, some of the electrodes can be peeled from the substrate due to a difference in coefficient of thermal expansion between the substrates and the electrodes at a high-temperature part side.

Meanwhile, one pair of a P-type thermoelectric leg and an N-type thermoelectric leg can be arranged on each of the plurality of electrodes. To this end, after printing a solder layer on each electrode, the P-type thermoelectric leg and the N-type thermoelectric leg can be bonded to the solder layer. In this case, when the P-type thermoelectric leg and the N-type thermoelectric leg slide and tilt on the solder layer or are bonded to each other, the solder layer flows out of the electrodes and overflows, and thus a short circuit failure can occur.

US 2013081663 A1 discloses a thermoelectric module including a metal layer surface treated for securing roughness at one surface thereof and a top substrate and a bottom substrate made of an insulating film formed on the surface treated one surface. US 2010096357 A1 discloses a thermoelectric module comprising lower electrodes formed on the inside surface of a lower substrate, placed in opposition to an upper substrate, on the inside surface of which are formed upper electrodes, wherein the end faces of thermoelectric elements are soldered to the lower electrodes and upper electrodes. KR 2016 0126804 A discloses a thermoelectric module including a first substrate having a plurality of first electrodes; a second substrate facing the first substrate and having a plurality of second electrodes; a plurality of thermoelectric elements disposed between the first substrate and the second substrate and electrically connected to the first electrode and the second electrode; and a solder pattern layer disposed among the first electrode and the second electrode and the thermoelectric element. KR 20160126805 A discloses a thermoelectric module including a first substrate having a plurality of first electrodes; a second substrate facing the first substrate and having a plurality of second electrodes; a plurality of thermoelectric elements disposed between the first substrate and the second substrate and electrically connected to the first electrode and the second electrode; a solder pattern layer disposed among the first electrode and the second electrode and the thermoelectric element; and a receiving groove for receiving the thermoelectric element and the solder pattern layer on the first substrate and the second substrate.

[Disclosure]

[Technical Problem]

The present invention is directed to providing an electrode structure of a thermoelectric element.

[Technical Solution]

One aspect of the present invention provides a thermoelectric element including: a first metal substrate; a first resin layer arranged on the first metal substrate; a plurality of first electrodes arranged on the first resin layer; a first electrode arranged on the first resin layer; a thermoelectric leg arranged on the first electrode; a second electrode arranged on the thermoelectric leg; a second resin layer arranged on the second electrode; and a second metal substrate arranged on the second resin layer, wherein an upper surface of the first resin layer includes a first electrode arrangement surface on which the first electrode is disposed, and a first concave surface disposed around the first electrode arrangement surface and toward the first metal substrate, wherein a lower surface of the second resin layer includes a second electrode arrangement surface on which the second electrode is disposed, and a second concave surface disposed around the second electrode arrangement surface and toward the second metal substrate, wherein a partial region of the first concave surface and a partial region of the second concave surface are vertically overlapped.
The first electrode arrangement surface of the first resin layer includes a first flat surface corresponding to a lower surface of the first electrode, the second electrode arrangement surface of the second resin layer includes a second flat surface corresponding to an upper surface of the second electrode, a partial region of the first electrode arrangement surface and a partial region of the second electrode arrangement surface are vertically overlapped with each other.
The first resin layer includes a first region of which an upper surface is the first electrode arrangement surface and a second region of which an upper surface is the first concave surface
A thickness of the first region and a minimum thickness of the second region differs from each other
The first resin layer further includes a third region which surrounds the second region and has a thickness greater than that of the first region and that of the sec-ond region.
The thickness of the first region is greater than the thickness of the second region the second resin layer includes a third region of which a lower surface is the second electrode arrangement surface and a fourth region of which a lower surface is the second concave surface.
A thickness of the third region and a minimum thickness of the fourth region differs from each other.
An upper surface of the first electrode includes a flat surface on which the thermoelectric leg is disposed and a first protruding surface disposed around the flat surface.
The first protruding surface includes a carbide.
The first protruding surface is continuously arranged around the flat surface of the first electrode.
At least one of the first resin layer and the second resin layer has a thick-ness of 0.02mm or more.
The least one of the first resin layer and the second resin layer has the thickness of 0.6mm or less.

[Advantageous Effects]

According to an embodiment of the present invention, a thermoelectric element having a simple manufacturing process, excellent thermal conductivity, and high reliability can be obtained. Specifically, according to the embodiment of the present invention, since a jig is not required for electrode arrangement, it is possible to implement thermoelectric elements of various sizes and shapes.

[Description of Drawings]

FIG. 1 is a cross-sectional view of a thermoelectric element, which are not falling under the scope of the appended claims and are considered merely as examples suitable for understanding the invention.

FIG. 2 is a view for describing a pair of a P-type thermoelectric leg and an N-type thermoelectric leg in the thermoelectric element, which are not falling under the scope of the appended claims and are considered merely as examples suitable for understanding the invention.

FIGS. 3 to 7 illustrate a bonding structure between a metal substrate and a resin layer of the thermoelectric element,

which are not falling under the scope of the appended claims and are considered merely as examples suitable for understanding the invention.

FIG. 8 is a cross-sectional view of the metal substrate, the resin layer, and electrodes of the thermoelectric element, which are not falling under the scope of the appended claims and are considered merely as examples suitable for understanding the invention.

FIG. 9 is a cross-sectional view of a metal substrate, a resin layer, and electrodes of a thermoelectric element, which are not falling under the scope of the appended claims and are considered merely as examples suitable for understanding the invention.

FIG. 10 is a cross-sectional view of a metal substrate, a resin layer, and electrodes of a thermoelectric element, which are not falling under the scope of the appended claims and are considered merely as examples suitable for understanding the invention.

FIG. 11 shows a top view and a cross-sectional view of the electrodes, which are not falling under the scope of the appended claims and are considered merely as examples suitable for understanding the invention.

FIG. 12 is a cross-sectional view of a metal substrate, a resin layer, electrodes, and thermoelectric legs of a thermoelectric element according to one embodiment of the present invention.

FIGS. 13 and 14 are a top view and a cross-sectional view of the electrodes of the thermoelectric element according to FIG. 12.

FIG. 15 is a cross-sectional view of a thermoelectric element according to yet another embodiment of the present invention.

FIGS. 16 and 17 are photographs taken after forming the electrodes by laser processing in accordance with the embodiment of the present invention, and FIG. 18 is a photograph taken after forming the electrodes by mechanical processing in accordance with the embodiment of the present invention.

FIG. 19 is a block diagram of a water purifier to which the thermoelectric element according to the embodiment of the present invention is applied.

FIG. 20 is a block diagram of a refrigerator to which the thermoelectric element according to the embodiment of the present invention is applied.

[Modes of the Invention]

Hereinafter, preferred embodiments of the present invention will be described in detail with reference to the accompanying drawings.

Further, terms used in the embodiments of the present invention (including technical and scientific terms), may be interpreted with meanings that are generally understood by those skilled in the art unless particularly defined and described, and terms which are generally used, such as terms defined in a dictionary, may be understood in consideration of their contextual meanings in the related art.

In addition, terms used in the description are provided not to limit the present invention but to describe the embodiments.

In the specification, the singular form may also include the plural form unless the context clearly indicates otherwise and may include one or more of all possible combinations of A, B, and C when disclosed as at least one (or one or more) of "A, B, and C".

In addition, terms such as first, second, A, B, (a), (b), and the like may be used to describe elements of the embodiments of the present invention.

The terms are only provided to distinguish the elements from other elements, and the essence, sequence, order, or the like of the elements are not limited by the terms.

Further, when particular elements are disclosed as being "connected," "coupled," or "linked" to other elements, the elements may include not only a case of being directly connected, coupled, or linked to other elements but also a case of being connected, coupled, or linked to other elements by elements between the elements and other elements.

In addition, when one element is disclosed as being formed "on or under" another element, the term "on or

under" includes both a case in which the two elements are in direct contact with each other and a case in which at least another element is disposed between the two elements (indirectly). Further, when the term "on or under" is expressed, a meaning of not only an upward direction but also a downward direction may be included based on one element.

FIG. 1 is a cross-sectional view of a thermoelectric element, and FIG. 2 is a view for describing a pair of a P-type thermoelectric leg and an N-type thermoelectric leg in the thermoelectric element.

Referring to FIGS. 1 and 2, a thermoelectric element 100 includes a first resin layer 110, a plurality of first electrodes 120, a plurality of P-type thermoelectric legs 130, a plurality of N-type thermoelectric legs 140, a plurality of second electrodes 150, and a second resin layer 160.

The plurality of first electrodes 120 are arranged between the first resin layer 110 and lower surfaces of the plurality of P-type thermoelectric legs 130 and the plurality of N-type thermoelectric legs 140, and the plurality of second electrodes 150 are arranged between the second resin layer 160 and upper surfaces of the plurality of P-type thermoelectric legs 130 and the plurality of N-type thermoelectric legs 140. Accordingly, the plurality of P-type thermoelectric legs 130 and the plurality of N-type thermoelectric legs 140 are electrically connected by the plurality of first electrodes 120 and the plurality of second electrodes 150. One pair of the P-type thermoelectric leg 130 and the N-type thermoelectric leg 140 which are arranged between the first electrode 120 and the second electrode 150 and electrically connected to each other may form a unit cell.

One pair of the P-type thermoelectric leg 130 and the N-type thermoelectric leg 140 may be arranged on each first electrode 120, and one pair of the P-type thermoelectric leg 130 and the N-type thermoelectric leg 140 may be arranged on each second electrode 150 so that one of one pair of the P-type thermoelectric leg 130 and the N-type thermoelectric leg 140 arranged on the first electrode 120 overlaps the second electrode 150.

Here, the P-type thermoelectric leg 130 and the N-type thermoelectric leg 140 may be bismuth-telluride (Bi-Te)-based thermoelectric legs including bismuth (Bi) and tellurium (Te) as main raw materials. The P-type thermoelectric leg 130 may be a thermoelectric leg including a bismuth-telluride (Bi-Te)-based main raw material in an amount of 99 to 99.999 wt% including at least one among antimony (Sb), nickel (Ni), aluminum (Al), copper (Cu), silver (Ag), lead (Pb), boron (B), gallium (Ga), tellurium (Te), bismuth (Bi), and indium (In), and a mixture in an amount of 0.001 to 1 wt% including Bi or Te based on 100 wt% of the total weight. For example, the main raw material may be Bi-Se-Te, and Bi or Te may be further included in an amount of 0.001 to 1 wt% of the total weight. The N-type thermoelectric leg 140 may be a thermoelectric leg including a bismuth-telluride (Bi-Te)-based main raw material in an amount of 99 to 99.999 wt% including at least one among selenium (Se), nickel (Ni), aluminum (Al), copper (Cu), silver (Ag), lead (Pb), boron (B), gallium (Ga), tellurium (Te), bismuth (Bi), and indium (In), and a mixture in an amount of 0.001 to 1 wt% including Bi or Te based on 100 wt% of the total weight. For example, the main raw material may be Bi-Sb-Te, and Bi or Te may be further included in an amount of 0.001 to 1 wt% of the total weight.

The P-type thermoelectric legs 130 and the N-type thermoelectric legs 140 may be formed in a bulk type or a stacked type. Generally, the bulk type P-type thermoelectric legs 130 or the bulk type N-type thermoelectric legs 140 may be obtained through a process of producing an ingot by heat-treating a thermoelectric material, pulverizing and sieving the ingot to obtain powder for thermoelectric legs, sintering the powder, and cutting the sintered object. The stacked type P-type thermoelectric legs 130 or the stacked type N-type thermoelectric legs 140 may be obtained through a process of forming a unit member by applying a paste including a thermoelectric material on a sheet-shaped base material, and then stacking and cutting the unit member.

In this case, one pair of the P-type thermoelectric leg 130 and the N-type thermoelectric leg 140 may have the same shape and volume or may have different shapes and volumes. For example, since electrical conduction characteristics of the P-type thermoelectric leg 130 and the N-type thermoelectric leg 140 are different, a height or cross-sectional area of the N-type thermoelectric leg 140 may be formed differently from a height or cross-sectional area of the P-type thermoelectric leg 130.

The performance of the thermoelectric element may be expressed as a thermoelectric performance index. The thermoelectric performance index (ZT) may be expressed as in Equation 1.

[Equation 1]

$$ZT = \alpha^2 \cdot \sigma \cdot T/k$$

Here, $\alpha$ is the Seebeck coefficient [V/K], $\sigma$ is electrical conductivity [S/m], and $\alpha^2\sigma$ is a power factor (W/mK$^2$]). Further, T is a temperature, and k is thermal conductivity [W/mK]. k may be expressed as a•cp•$\rho$, wherein a is thermal diffusivity [cm$^2$/S], cp is specific heat [J/gK], and $\rho$ is density [g/cm$^3$].

In order to obtain the thermoelectric performance index of the thermoelectric element, a Z value (V/K) is measured using a Z meter, and the thermoelectric performance index (ZT) may be calculated using the measured Z value.

The P-type thermoelectric legs 130 and the N-type thermoelectric legs 140 may have a structure shown in FIG.

2B. Referring to FIG. 2B, the thermoelectric legs 130 and 140 include thermoelectric material layers 132 and 142, first plated layers 134-1 and 144-1 stacked on one surfaces of the thermoelectric material layers 132 and 142, second plated layers 134-2 and 144-2 stacked on the other surfaces arranged opposite the one surfaces of the thermoelectric material layers 132 and 142, first bonding layers 136-1 and 146-1 and second bonding layers 136-2 and 146-2 respectively arranged between the thermoelectric material layers 132 and 142 and the first plated layers 134-1 and 144-1 and between the thermoelectric material layers 132 and 142 and the second plated layers 134-2 and 144-2, and first metal layers 138-1 and 148-1 and second metal layers 138-2 and 148-2 respectively stacked on the first plated layers 134-1 and 144-1 and the second plated layers 134-2 and 144-2.

In this case, the thermoelectric material layers 132 and 142 and the first bonding layers 136-1 and 146-1 may come into direct contact with each other, and the thermoelectric material layers 132 and 142 and the second bonding layers 136-2 and 146-2 may come into direct contact with each other. Further, the first bonding layers 136-1 and 146-1 and the first plated layers 134-1 and 144-1 may come into direct contact with each other, and the second bonding layers 136-2 and 146-2 and the second plated layers 134-2 and 144-2 may come into direct contact with each other. In addition, the first plated layers 134-1 and 144-1 and the first metal layers 138-1 and 148-1 may come into direct contact with each other, and the second plated layers 134-2 and 144-2 and the second metal layers 138-2 and 148-2 may come into direct contact with each other.

Here, the thermoelectric material layers 132 and 142 may include bismuth (Bi) and tellurium (Te), which are semiconductor materials. The thermoelectric material layers 132 and 142 may have the same material or shape as the P-type thermoelectric legs 130 or the N-type thermoelectric legs 140 shown in FIGS. 1 and 2A.

Further, the first metal layers 138-1 and 148-1 and the second metal layers 138-2 and 148-2 may be selected from copper (Cu), a copper alloy, aluminum (Al) and an aluminum alloy, and may each have a thickness of 0.1 to 0.5 mm, and preferably, 0.2 to 0.3 mm. Since coefficients of thermal expansion of the first metal layers 138-1 and 148-1 and the second metal layers 138-2 and 148-2 are similar to or greater than those of the thermoelectric material layers 132 and 142, compressive stress is applied at interfaces between the first metal layers 138-1 and 148-1 and the second metal layers 138-2 and 148-2, and the thermoelectric material layers 132 and 142 during sintering, and thus cracks or peeling may be prevented. Further, since a bonding force between the first metal layers 138-1 and 148-1 and the second metal layers 138-2 and 148-2, and the electrodes 120 and 150 is high, the thermoelectric legs 130 and 140 may be stably coupled to the electrodes 120 and 150.

Next, the first plated layers 134-1 and 144-1 and the second plated layers 134-2 and 144-2 may each include at least one of Ni, Sn, Ti, Fe, Sb, Cr, and Mo, and may have a thickness of 1 to 20 μm, and preferably 1 to 10 μm. Since the first plated layers 134-1 and 144-1 and the second plated layers 134-2 and 144-2 prevent a reaction between Bi or Te which is a semiconductor material in the thermoelectric material layers 132 and 142, and the first metal layers 138-1 and 148-1 and the second metal layers 138-2 and 148-2, performance degradation of the thermoelectric element may be prevented, and oxidation of the first metal layers 138-1 and 148-1 and the second metal layers 138-2 and 148-2 may also be prevented.

In this case, the first bonding layers 136-1 and 146-1 and the second bonding layers 136-2 and 146-2 may be respectively arranged between the thermoelectric material layers 132 and 142 and the first plated layers 134-1 and 144-1 and between the thermoelectric material layers 132 and 142 and the second plated layers 134-2 and 144-2. In this case, the first bonding layers 136-1 and 146-1 and the second bonding layers 136-2 and 146-2 may include Te. For example, the first bonding layers 136-1 and 146-1 and the second bonding layers 136-2 and 146-2 may include at least one among Ni-Te, Sn-Te, Ti-Te, Fe-Te, Sb-Te, Cr-Te, and Mo-Te. The first bonding layers 136-1 and 146-1 and the second bonding layers 136-2 and 146-2 may each have a thickness of 0.5 to 100 μm, and preferably, 1 to 50 μm. The first bonding layers 136-1 and 146-1 and the second bonding layers 136-2 and 146-2 including Te may be arranged between the thermoelectric material layers 132 and 142, and the first plated layers 134-1 and 144-1 and the second plated layers 134-2 and 144-2 in advance to prevent the diffusion of Te in the thermoelectric material layers 132 and 142 to the first plated layers 134-1 and 144-1 and the second plated layers 134-2 and 144-2. Accordingly, it is possible to prevent the generation of a Bi-rich region.

Accordingly, a Te content is higher than a Bi content from center portions of the thermoelectric material layers 132 and 142 to interfaces between the thermoelectric material layers 132 and 142 and the first bonding layers 136-1 and 146-1, and a Te content is higher than a Bi content from the center portions of the thermoelectric material layers 132 and 142 to interfaces between the thermoelectric material layers 132 and 142 and the second bonding layers 136-2 and 146-2. The Te content from the center portions of the thermoelectric material layers 132 and 142 to interfaces between the thermoelectric material layers 132 and 142 and the first bonding layers 136-1 and 146-1 or the Te content from the center portions of the thermoelectric material layers 132 and 142 to interfaces between the thermoelectric material layers 132 and 142 and the second bonding layers 136-2 and 146-2 may be 0.8 to 1 times the Te content in the center portions of the thermoelectric material layers 132 and 142. For example, the Te content within a thickness of 100 μm from the interfaces between the thermoelectric material layers 132 and 142 and the first bonding layers 136-1 and 146-1 in directions toward the center portions of the thermoelectric material layers 132 and 142 may be 0.8 to 1

times the Te content in the center portions of the thermoelectric material layers 132 and 142. Here, the Te content may be uniformly maintained within the thickness of 100 μm from the interfaces between the thermoelectric material layers 132 and 142 and the first bonding layers 136-1 and 146-1 in the directions toward the center portions of the thermoelectric material layers 132 and 142, and for example, a change rate of a Te weight ratio within the thickness of 100 μm from the interfaces between the thermoelectric material layers 132 and 142 and the first bonding layers 136-1 and 146-1 in the directions toward the center portions of the thermoelectric material layers 132 and 142 may be 0.9 to 1.

Further, a Te content in the first bonding layers 136-1 and 146-1 or the second bonding layers 136-2 and 146-2 may be the same as or similar to a Te content in the thermoelectric material layers 132 and 142. For example, the Te content in the first bonding layers 136-1 and 146-1 or the second bonding layers 136-2 and 146-2 may be 0.8 to 1 times, preferably, 0.85 to 1 times, more preferably, 0.9 to 1 times, and more preferably, 0.95 to 1 times the Te content in the thermoelectric material layers 132 and 142. Here, the content may be a weight ratio. For example, when the Te content in the thermoelectric material layers 132 and 142 is included at 50 wt%, the Te content in the first bonding layers 136-1 and 146-1 or the second bonding layers 136-2 and 146-2 may be 40 to 50wt%, preferably, 42.5 to 50wt%, more preferably, 45 to 50wt%, and more preferably, 47.5 to 50wt%. Further, the Te content in the first bonding layers 136-1 and 146-1 or the second bonding layers 136-2 and 146-2 may be greater than an Ni content. In the first bonding layers 136-1 and 146-1 or the second bonding layers 136-2 and 146-2, the Te content is uniformly distributed, but the Ni content may decrease while being adjacent in directions toward the thermoelectric material layers 132 and 142 in the first bonding layers 136-1 and 146-1 or the second bonding layers 136-2 and 146-2.

Further, a Te content from the interfaces between the thermoelectric material layers 132 and 142 and the first bonding layers 136-1 and 146-1 or the interfaces between the thermoelectric material layers 132 and 142 and the second bonding layers 136-2 and 146-2 to interfaces between the first plated layers 136-1 and 146-1 and the first bonding layers 136-1 and 146-1 or interfaces between the second plated layers 134-2 and 144-2 and the second bonding layers 136-2 and 146-2 may be uniformly distributed. For example, a change rate of a Te weight ratio from the interfaces between the thermoelectric material layers 132 and 142 and the first bonding layers 136-1 and 146-1 or the interfaces between the thermoelectric material layers 132 and 142 and the second bonding layers 136-2 and 146-2 to the interfaces between the first plated layers 136-1 and 146-1 and the first bonding layers 136-1 and 146-1 or the interfaces between the second plated layers 134-2 and 144-2 and the second bonding layers 136-2 and 146-2 may be 0.8 to 1. Here, the Te content from the interfaces between the thermoelectric material layers 132 and 142 and the first bonding layers 136-1 and 146-1 or the interfaces between the thermoelectric material layers 132 and 142 and the second bonding layers 136-2 and 146-2 to the interfaces between the first plated layers 136-1 and 146-1 and the first bonding layers 136-1 and 146-1 or the interfaces between the second plated layers 134-2 and 144-2 and the second bonding layers 136-2 and 146-2 may be uniformly distributed as the change rate of the Te weight ratio becomes closer to 1.

Further, the Te content at surfaces in the first bonding layers 136-1 and 146-1 which come into contact with the first plated layers 134-1 and 144-1, that is, the interfaces between the first plated layers 136-1 and 146-1 and the first bonding layers 136-1 and 146-1 or surfaces in the second bonding layers 136-2 and 146-2 which come into contact with the second plated layers 134-2 and 144-2, that is, the interfaces between the second plated layers 134-2 and 144-2 and the second bonding layers 136-2 and 146-2 may be 0.8 to 1 times, preferably, 0.85 to 1 times, more preferably, 0.9 to 1 times, and more preferably, 0.95 to 1 times the Te content at surfaces in the thermoelectric material layers 132 and 142 which come into contact with the first bonding layers 136-1 and 146-1, that is, the interfaces between the thermoelectric material layers 132 and 142 and the first bonding layers 136-1 and 146-1 or surfaces in the thermoelectric material layers 132 and 142 which come into contact with the second bonding layers 136-2 and 146-2, that is, the interfaces between the thermoelectric material layers 132 and 142 and the second bonding layers 136-2 and 146-2. Here, the content may be a weight ratio.

Further, it can be seen that the Te content in the center portions of the thermoelectric material layers 132 and 142 is the same as or similar to the Te content at the interfaces between the thermoelectric material layers 132 and 142 and the first bonding layers 136-1 and 146-1 or the interfaces between the thermoelectric material layers 132 and 142 and the second bonding layers 136-2 and 146-2. That is, the Te content in the interfaces between the thermoelectric material layers 132 and 142 and the first bonding layers 136-1 and 146-1 or the interfaces between the thermoelectric material layers 132 and 142 and the second bonding layers 136-2 and 146-2 may be 0.8 to 1 times, preferably, 0.85 to 1 times, more preferably, 0.9 to 1 times, and more preferably, 0.95 to 1 times the Te content in the center portions of the thermoelectric material layers 132 and 142. Here, the content may be a weight ratio. Here, the center portions of the thermoelectric material layers 132 and 142 may refer to surrounding regions including centers of the thermoelectric material layers 132 and 142. Further, the interface may refer to the interface itself, or may refer to the interface and surrounding regions of the interface adjacent to the interface within a predetermined distance.

In addition, the Te content in the first plated layers 136-1 and 146-1 or the second plated layers 134-2 and 144-2 may be smaller than the Te content in the thermoelectric material layers 132 and 142 and the Te content in the first bonding layers 136-1 and 146-1 or the second bonding layers 136-2 and 146-2.

In addition, it can be seen that a Bi content in the center portions of the thermoelectric material layers 132 and

142 is the same as or similar to a Bi content at the interfaces between the thermoelectric material layers 132 and 142 and the first bonding layers 136-1 and 146-1 or the interfaces between the thermoelectric material layers 132 and 142 and the second bonding layers 136-2 and 146-2. Accordingly, since the Te content is greater than the Bi content from the center portions of the thermoelectric material layers 132 and 142 to the interfaces between the thermoelectric material layers 132 and 142 and the first bonding layers 136-1 and 146-1 or the interfaces between the thermoelectric material layers 132 and 142 and the second bonding layers 136-2 and 146-2, a section in which the Bi content overtakes the Te content is not present around the interfaces between the thermoelectric material layers 132 and 142 and the first bonding layers 136-1 and 146-1 or the interfaces between the thermoelectric material layers 132 and 142 and the second bonding layers 136-2 and 146-2. For example, the Bi content in the center portions of the thermoelectric material layers 132 and 142 may be 0.8 to 1 times, preferably, 0.85 to 1 times, more preferably, 0.9 to 1 times, and more preferably, 0.95 to 1 times the Bi content at the interfaces between the thermoelectric material layers 132 and 142 and the first bonding layers 136-1 and 146-1 or the interfaces between the thermoelectric material layers 132 and 142 and the second bonding layers 136-2 and 146-2. Here, the content may be a weight ratio.

Here, the plurality of first electrodes 120 arranged between the first resin layer 110, and the P-type thermoelectric legs 130 and the N-type thermoelectric legs 140, and the plurality of second electrodes 150 arranged between the second resin layer 160, and the P-type thermoelectric legs 130 and the N-type thermoelectric legs 140 may include at least one among copper (Cu), silver (Ag) and nickel (Ni).

Further, the first resin layer 110 and the second resin layer 160 may be formed to have different sizes. For example, a volume, a thickness, or an area of one of the first resin layer 110 and the second resin layer 160 may be formed to be larger than a volume, a thickness, or an area of the other one. Accordingly, it is possible to increase the heat absorption performance or heat dissipation performance of the thermoelectric element.

In this case, the P-type thermoelectric leg 130 or the N-type thermoelectric leg 140 may have a cylindrical shape, a polygonal pillar shape, an oval pillar shape, or the like.

Alternatively, the P-type thermoelectric leg 130 or the N-type thermoelectric leg 140 may have a stacked structure. For example, the P-type thermoelectric leg 130 or the N-type thermoelectric leg 140 may be formed using a method of stacking a plurality of structures in which a semiconductor material is applied on a sheet-shaped base material and then cutting the structures. Accordingly, material loss may be prevented and electrical conduction characteristics may be enhanced.

Alternatively, the P-type thermoelectric leg 130 or the N-type thermoelectric leg 140 may be manufactured according to a zone melting method or a powder sintering method. According to the zone melting method, the thermoelectric leg is obtained through a method of manufacturing an ingot using a thermoelectric material, refining so that particles are rearranged in a single direction by slowly applying heat to the ingot, and slowly cooling the ingot. According to the powder sintering method, the thermoelectric leg is obtained through a process of manufacturing an ingot using a thermoelectric material, pulverizing and sieving the ingot to obtain powder for thermoelectric legs, and sintering the powder.

The first resin layer 110 may be arranged on a first metal substrate 170, and a second metal substrate 180 may be arranged on the second resin layer 160.

The first metal substrate 170 and the second metal substrate 180 may be formed of aluminum, an aluminum alloy, copper, a copper alloy, or the like. The first metal substrate 170 and the second metal substrate 180 may support the first resin layer 110, the plurality of first electrodes 120, the plurality of P-type thermoelectric legs 130, the plurality of N-type thermoelectric legs 140, the plurality of second electrodes 150, the second resin layer 160, and the like, and may be regions directly attached to an application to which the thermoelectric element 100. Accordingly, the first metal substrate 170 and the second metal substrate 180 may be interchanged with a first metal support and a second metal support, respectively.

An area of the first metal substrate 170 may be larger than an area of the first resin layer 110, and an area of the second metal substrate 180 may be larger than an area of the second resin layer 160. That is, the first resin layer 110 may be arranged in a region spaced apart from an edge of the first metal substrate 170 by a predetermined distance, and the second resin layer 160 may be arranged in a region spaced apart from an edge of the second metal substrate 180 by a predetermined distance.

The first resin layer 110 and the second resin layer 160 may be formed of an epoxy resin composition including an epoxy resin and an inorganic filler. Here, the inorganic filler may be included at 68 to 88 vol% of the epoxy resin composition. When the inorganic filler is included in an amount less than 68 vol%, a heat conduction effect may be low, and when the inorganic filler is included in an amount greater than 88 vol%, adhesion between the resin layer and the metal substrate may be lowered, and the resin layer may be easily broken.

Thicknesses of the first resin layer 110 and the second resin layer 160 may each be 0.02 to 0.6 mm, preferably, 0.1 to 0.6 mm, and more preferably, 0.2 to 0.6 mm, and thermal conductivity may be 1W/mK or more, preferably, 10W/mK or more, and more preferably, 20W/mK or more.

The epoxy resin may include an epoxy compound and a curing agent. In this case, the curing agent may be

included in a volume ratio of 1 to 10 with respect to a volume ratio of 10 of the epoxy compound. Here, the epoxy compound may include at least one of a crystalline epoxy compound, an amorphous epoxy compound, and a silicone epoxy compound. The crystalline epoxy compound may include a mesogen structure. A mesogen is a basic unit of liquid crystal, and includes a rigid structure. Further, the amorphous epoxy compound may be a general amorphous epoxy compound having two or more epoxy groups in a molecule, and may be, for example, glycidyl ethers derived from bisphenol A or bisphenol F. Here, the curing agent may include at least one of an amine-based curing agent, a phenolic curing agent, an acid anhydride-based curing agent, a polymercaptan-based curing agent, a polyaminoamide-based curing agent, an isocyanate-based curing agent, and a block isocyanate curing agent, and two or more types of the curing agents may be mixed and used.

The inorganic filler may include an oxide or a nitride, and the nitride may be included in an amount of 55 to 95 wt% of the inorganic filler, and more preferably, 60 to 80 wt%. When the nitride is included in this numerical range, thermal conductivity and bonding strength may be enhanced. Here, the oxide may include at least one of aluminum oxide, titanium oxide, and zinc oxide, and the nitride may include at least one of boron nitride and aluminum nitride. Here, when the nitride includes boron nitride, the boron nitride may be applied in a shape of a boron nitride agglomerate in which a plate-shaped boron nitride is agglomerated, and a surface of the boron nitride agglomerate may be coated with a polymer having the following Unit 1, or at least some of voids in the boron nitride aggregate may be filled by the polymer having the following Unit 1.

Unit 1 is as follows.

[Unit 1]

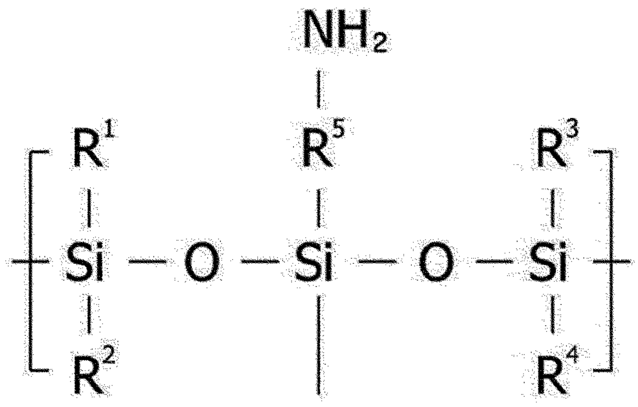

Here, one of $R^1$, $R^2$, $R^3$ and $R^4$ may be H, and the others may be selected from the group consisting of $C_1$-$C_3$ alkyls, $C_2$-$C_3$ alkenes, and $C_2$-$C_3$ alkynes, and $R^5$ may be a linear, branched or cyclic divalent organic linker having 1 to 12 carbon atoms.

One of the remainder among $R^1$, $R^2$, $R^3$ and $R^4$ except for H may be selected from $C_2$-$C_3$ alkenes, and another and still another of the remainder may be selected from $C_1$-$C_3$ alkyls. For example, the polymer resin may include the following Unit 2.

[Unit 2]

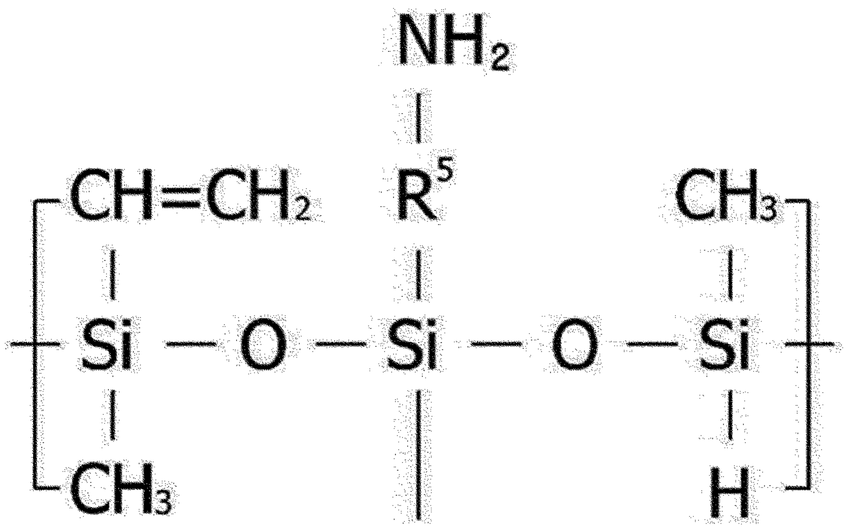

Alternatively, the remainder among $R^1$, $R^2$, $R^3$ and $R^4$ except for H may be selected from the group consisting of $C_1$-$C_3$ alkyls, $C_2$-$C_3$ alkenes, and $C_2$-$C_3$ alkynes to be different from each other.

Like the above, when the polymer according to Unit 1 or Unit 2 is coated on the boron nitride agglomerate in which the plate-shaped boron nitride is agglomerated and fills at least some of the voids in the boron nitride agglomerate, an air layer in the boron nitride agglomerate is minimized to increase heat conduction performance of the boron nitride agglomerate, and breakage of the boron nitride aggregate may be prevented by increasing a bonding force between the plate-shaped boron nitride. Further, when a coating layer is formed on the boron nitride agglomerate in which the plate-shaped boron nitride is aggregated, forming a functional group becomes easy, and when a functional group is formed on the coating layer of the boron nitride agglomerate, affinity with the resin may increase.

In this case, a particle size (D50) of the boron nitride agglomerate may be 250 to 350 μm, and a particle size (D50) of the aluminum oxide may be 10 to 30 μm. When the particle size (D50) of the boron nitride agglomerate and the particle size (D50) of the aluminum oxide satisfy these numerical ranges, the boron nitride agglomerate and the aluminum oxide may be uniformly dispersed in the epoxy resin composition, and accordingly, it is possible to have a uniform heat conduction effect and adhesion performance throughout the resin layer.

Alternatively, at least one of the first resin layer 110 and the second resin layer 160 may be a silicone resin composition including a silicone resin and an inorganic filler, and the silicone resin may include, for example, polydimethylsiloxane (PDMS).

Although not shown, at least one of the first resin layer 110 and the second resin layer 160 may be formed as a plurality of layers. In this case, each of the plurality of layers may be formed by including a resin composition or an inorganic filler which is the same or different from each other, and the layers may have different thicknesses. Accordingly, it is possible to further enhance at least one of an insulating property, bonding strength, and heat conduction performance of at least one of the first resin layer 110 and the second resin layer 160.

FIGS. 3 to 7 illustrate a bonding structure between a metal substrate and a resin layer of the thermoelectric element. For convenience of description, the first metal substrate 170 and the first resin layer 110 will be described as examples, but the same structure may be applied between the second metal substrate 180 and the second resin layer 160.

Referring to FIGS. 3 to 5, a surface on which the first resin layer 110 is arranged among both surfaces of the first metal substrate 170, that is, a surface facing the first resin layer 110 among both surfaces of the first metal substrate 170, may include a first region 172 and a second region 174, and the second region 174 may be arranged in the first region 172. That is, the first region 172 may be arranged within a predetermined distance from an edge of the first metal substrate 170 toward a center region, and the first region 172 may surround the second region 174.

In this case, a surface roughness of the second region 174 may be larger than a surface roughness of the first region 172, and the first resin layer 110 may be arranged on the second region 174. Here, the first resin layer 110 may be arranged to be spaced apart by a predetermined distance from a boundary between the first region 172 and the second region 174. That is, the first resin layer 110 may be arranged on the second region 174, and the edge of the first resin layer 110 may be located in the second region 174. Accordingly, in at least some of grooves 400 formed by the surface roughness of the second region 174, a part of the first resin layer 110, that is, an epoxy resin 600 and a portion 604 of the inorganic filler included in the first resin layer 110 may permeate, and adhesion between the first resin layer 110 and the first metal substrate 170 may increase.

However, the surface roughness of the second region 174 may be larger than the particle size (D50) of a part of the inorganic filler included in the first resin layer 110 and smaller than the particle size (D50) of the other part of the

inorganic filler. Here, the particle size (D50) may refer to a particle diameter corresponding to 50% of a weight percentage in a particle size distribution curve, that is, a particle diameter at which a passing mass percentage becomes 50%, and may be interchanged with an average particle diameter. In an example in which the first resin layer 110 includes aluminum oxide and boron nitride as inorganic fillers, the aluminum oxide does not affect the adhesion performance between the first resin layer 110 and the first metal substrate 170, but the boron nitride has a smooth surface, and thus the adhesion performance between the first resin layer 110 and the first metal substrate 170 may be adversely affected. Accordingly, when the surface roughness of the second region 174 is formed to be larger than the particle size (D50) of the aluminum oxide included in the first resin layer 110, and smaller than the particle size (D50) of the boron nitride, since only the aluminum oxide is arranged in the grooves formed by the surface roughness of the second region 174, and the boron nitride may not be arranged in the grooves, the first resin layer 110 and the first metal substrate 170 may maintain high bonding strength.

Accordingly, the surface roughness of the second region 174 may be 1.05 to 1.5 times the particle size (D50) of an inorganic filler 604 having a relatively small size among the inorganic fillers included in the first resin layer 110, for example, the aluminum oxide, and may be 0.04 to 0.15 times the particle size (D50) of an inorganic filler 602 having a relatively large size among the inorganic fillers included in the first resin layer 110, for example, the boron nitride.

As described above, when the particle size (D50) of the boron nitride agglomerate is 250 to 350 μm, and the particle size (D50) of the aluminum oxide is 10 to 30 μm, the surface roughness of the second region 174 may be 1 to 50 μm. Accordingly, in the grooves formed by the surface roughness of the second region 174, only the aluminum oxide may be arranged, and the boron nitride agglomerate may not be arranged.

Accordingly, contents of the epoxy resin and the inorganic filler in the grooves formed by the surface roughness of the second region 174 may be different from contents of the epoxy resin and the inorganic filler in a middle region between the first metal substrate 170 and the plurality of first electrodes 120.

The surface roughness may be measured using a surface roughness meter. The surface roughness meter may measure a cross-sectional curve using a probe, and calculate the surface roughness using a peak line, a valley bottom line, an average line, and a reference length of the cross-sectional curve. In this specification, the surface roughness may refer to an arithmetic average roughness (Ra) by a center line average calculation method. The arithmetic average roughness (Ra) may be obtained through the following Equation 2.

[Equation 2]

$$R_a = \frac{1}{L}\int_0^L |f(x)|\,dx$$

That is, when the cross-sectional curve obtained by the probe of the surface roughness meter is extracted as much as a reference length L and expressed as the function (f(x)) with an average line direction set to an x-axis and a height direction set to a y-axis, the value obtained by Equation 2 may be expressed in micrometers.

Referring to FIGS. 6 and 7, the surface on which the first resin layer 110 is arranged among both surfaces of the first metal substrate 170, that is, the surface facing the first resin layer 110 among both surfaces of a the first metal substrate 170 may include the first region 172 and the second region 174 surrounded by the first region 172 and having a larger surface roughness than the first region 172, and may further include a third region 176.

Here, the third region 176 may be arranged in the second region 174. That is, the third region 176 may be arranged to be surrounded by the second region 174. Further, the surface roughness of the second region 174 may be formed larger than a surface roughness of the third region 176.

In this case, the first resin layer 110 may be arranged to be spaced apart from a boundary between the first region 172 and the second region 174 by a predetermined distance, and may be arranged to cover a part of the second region 174 and the third region 176.

In order to increase the bonding strength between the first metal substrate 170 and the first resin layer 110, an adhesion layer 800 may be further arranged between the first metal substrate 170 and the first resin layer 110.

The adhesive layer 800 may be the same epoxy resin composition as an epoxy resin composition forming the first resin layer 110. For example, after applying the same epoxy resin composition as the epoxy resin composition forming the first resin layer 110 in an uncured state between the first metal substrate 170 and the first resin layer 110, the first metal substrate 170 and the first resin layer 110 may be bonded to each other in a method of stacking the first resin layer 110 in a cured state, and then pressing the first resin layer 110 at a high temperature.

In this case, a part of the adhesive layer 800, for example, a part of the epoxy resin of the epoxy resin composition constituting the adhesive layer 800 and a part of the inorganic filler may be arranged in at least some of the grooves in

the second region 174 according to the surface roughness.

FIG. 8 is a cross-sectional view of the metal substrate, the resin layer, and electrodes of the thermoelectric element, FIG. 9 is a cross-sectional view of a metal substrate, a resin layer, and electrodes of a thermoelectric element, FIG. 10 is a cross-sectional view of a metal substrate, a resin layer, and electrodes of a thermoelectric element, and FIG. 11 shows a top view and a cross-sectional view of the electrodes. For convenience of description, the first metal substrate 170, the first resin layer 110, and the plurality of first electrodes 120 are described as examples, but the present invention is not limited thereto, and the same structure may also be applied to the second metal substrate 180, the second resin layer 160 and the plurality of second electrodes 150. Further, one first electrode 120 among the plurality of first electrodes 120 is described as an example, but the same structure may be applied to all or some of the plurality of first electrodes 120.

Referring to FIGS. 8 to 11, the first electrode 120 includes a first surface 121 which comes into contact with the first resin layer 110, a second surface 122 facing the first surface 121 and on which one pair of the P-type thermoelectric leg 130 and the N-type thermoelectric leg 140 are arranged, and a first protruding part 123 arranged along an edge of the second surface 122. A plated layer, for example, an Ni/Sn plated layer may be formed on the surface of the first electrode 120. The first protruding part 123 may protrude upward on the second surface 122. In this case, as shown in FIG. 11A, the first protruding part 123 may be continuously arranged along the edge of the second surface 122. For example, when the second surface 122 of the first electrode 120 has a rectangular shape, the first protruding part 123 may be continuously arranged along the edges of the rectangular shape without disconnection. Like the above, when the first protruding part 123 is arranged along the edge of the second surface 122, a problem in that a solder layer flows out of the first electrodes 120 and a short circuit of the electrodes occurs when one pair of the P-type thermoelectric leg 130 and the N-type thermoelectric leg 140 are bonded to the second surface 122 by soldering may be prevented. In order to prevent the problem that the solder layer goes over the first protruding part 123 and flows out of the first electrode 120, the first protruding part 123 and one pair of the P-type thermoelectric leg 130 and the N-type thermoelectric leg 140 may be arranged to be spaced apart from each other at a predetermined interval. Accordingly, the solder layer may be accommodated between the first protruding part 123 and one pair of the P-type thermoelectric leg 130 and the N-type thermoelectric leg 140. Further, a problem in that the P-type thermoelectric leg 130 and the N-type thermoelectric leg 140 are tilted on the second surface 122 or separated from the second surface 122 may be prevented.

In this case, as shown in FIG. 8, the first protruding part 123 may be formed of the same material as the material forming the first electrode 120, that is, the material forming the second surface 122. Alternatively, as shown in FIG. 9, the first protruding part 123 includes a material in which the material forming the second surface 122 is carbonized, that is, a carbide, and thus also includes carbon. In this case, a side surface of the first electrode 120 may also include carbon. Here, a carbon content of the carbide is 30 wt% or more, and preferably, 50 wt% or more.

In this case, a surface of the first protruding part 123 may have a curved surface, and a cross-sectional shape of the first electrode 120 including the first protruding part 123 may have a cup shape in which an edge height is high, and a height of a region where one pair of the P-type thermoelectric leg 130 and the N-type thermoelectric leg 140 are arranged is low. For example, as shown in FIG. 11B, the height of the first protruding part 123 may be lowered as the first protruding part 123 becomes closer to the region where one pair of the P-type thermoelectric leg 130 and the N-type thermoelectric leg 140 are arranged from the edge of the second surface 122. Alternatively, as shown in FIG. 11C, the height of the first protruding part 123 may increase and then decrease again as the first protruding part 123 becomes closer to the region where one pair of the P-type thermoelectric leg 130 and the N-type thermoelectric leg 140 are arranged from the edge of the second surface 122. That is, a cross section of the first protruding part 123 may have a curved mountain shape.

Here, the cross section of the first protruding part 123 is shown to have a smooth curved shape, but is not limited thereto, and the cross section of the first protruding part 123 may have a pointed shape or may have a random shape.

Here, a width W1 of the first protruding part 123 may be 5 to 20% of a width W2 of the first electrode 120. Here, the width W2 of the first electrode 120 may be a width of an entire electrode including the first protruding part 123, and may refer to a long width of an upper surface of the first electrode 120 when the first electrode 120 has a rectangular shape. Here, the long width may refer to a width of a long side in the rectangular shape. Here, when the width W1 of the first protruding part 123 is less than 5% of the width W2 of the first electrode 120, the first protruding part 123 may not sufficiently perform a separation prevention function of the P-type thermoelectric leg 130 and the N-type thermoelectric leg 140, and the first protruding part 123 may be easily broken and act as a foreign material on the thermoelectric element 100. Further, when the width W1 of the first protruding part 123 exceeds 20% of the width W2 of the first electrode 120, a region for mounting the P-type thermoelectric leg 130 and the N-type thermoelectric leg 140 on the first electrode 120 may be reduced, and accordingly, since a resistance value of the element may increase based on the thermoelectric device having the same height, the characteristics of the thermoelectric element may be degraded.

Meanwhile, a thickness d1 of the first resin layer 110 arranged between the neighboring first electrodes 120 may be smaller than a thickness d2 of the first resin layer 110 arranged under the first surface 121. That is, the thickness

of the first resin layer 110 arranged at a side lower portion of the first electrode 120 may be smaller than the thickness of the first resin layer 110 arranged under the first surface 121.

For example, the thickness of the first resin layer 110 arranged between the neighboring first electrodes 120 may increase as the first resin layer 110 becomes closer to the neighboring first electrodes 120. That is, the thickness of the first resin layer 110 arranged between the neighboring first electrodes 120 may become smaller while becoming more distant from the edge of the first surface 121 of each first electrode 120, and closer to an intermediate point between the neighboring first electrodes 120. That is, a V-shaped or U-shaped groove may be formed in the first resin layer 110 arranged between the neighboring first electrodes 120.

For example, as shown in FIG. 10, the first metal substrate 170 may be exposed in at least some regions between the neighboring first electrodes 120.

Accordingly, insulation between the first electrode 120 and the first metal substrate 170 may be maintained, heat conduction performance between the first electrode 120 and the first metal substrate 170 may be enhanced, and since there is no problem that the first resin layer 110 flows into an upper portion of the first electrode 120, electrical conductivity of the first electrode 120 may also be enhanced.

In this case, a height H1 of the first protruding part 123 may be 2 to 35% of a sum H2 of a height of the first electrode 120 and a height of the groove formed in the first resin layer 110, that is, a depth to be actually processed from the top surface of the first electrode 120. When the height H1 of the first protruding part 123 is less than 2% of the sum H2 of the height of the first electrode 120 and the height of the groove formed in the first resin layer 110, the first protruding part 123 may not sufficiently perform the separation prevention function of the P-type thermoelectric leg 130 and the N-type thermoelectric leg 140, and the first protruding part 123 may be easily broken and then act as a foreign material on the thermoelectric element 100. Further, when the height H1 of the first protruding part 123 exceeds 35% of the sum H2 of the height of the first electrode 120 and the height of the groove formed in the first resin layer 110, since a height between a printing mask and the surface of the first electrode 120 becomes too high when the solder layer is printed to mount the P-type thermoelectric leg 130 and the N-type thermoelectric leg 140 on the first electrode 120, a process of printing the solder layer may not smoothly proceed.

After bonding a plate-shaped metal layer on the first resin layer 110 applied onto the first metal substrate 170 in an uncured or semi-cured state, the metal layer may be cut by a machine or laser processing to form the plurality of first electrodes 120. When the metal layer is cut by a machine, as shown in FIG. 8, the first protruding part 123 formed of the same material as the material forming the second surface 122 may be formed on the edge of the second surface 122. When the metal layer is cut by a machine, a plated layer formed on the surface of the metal layer, for example, an Ni/Sn plated layer, may be peeled off during mechanical cutting, and accordingly, a metal forming the metal layer, for example, copper may be exposed to the outside. As described above, when solder layer is printed to mount the P-type thermoelectric leg 130 and the N-type thermoelectric leg 140 on the first electrode 120, since the copper and the solder layer have poor wettability, it is difficult to adhere the solder layer to a surface of the copper, and accordingly, a problem in that the solder layer flows out of the first electrode 120 may be prevented.

When the metal layer is cut by laser processing, a cut surface of the metal layer is carbonized by burning of the laser, and accordingly, as shown in FIG. 9, the first protruding part 123 may include carbon, and the side surface of the first electrode 120 formed by the laser processing may also include carbon. Since the carbon is a material having an electrical insulation property, accordingly, an insulation effect between electrodes may be expected.

Meanwhile, a hardness of the first resin layer 110 may be lower than a hardness of the metal layer. Accordingly, when the metal layer is cut by a machine or laser processing to form the plurality of first electrodes 120, at least a part of the first resin layer 110 may also be deleted. In this case, the height at which the first resin layer 110 is removed may vary according to laser output or the like.

Like the above, in the case of arranging the plate-shaped metal layer on the first resin layer 110 and then cutting the metal layer using a machine or laser processing the metal layer to form the plurality of first electrodes 120, a process and costs can be reduced compared to the case of aligning the plurality of first electrodes 120 on the jig and then arranging the first electrodes 120 on the first resin layer 110, and various electrode shapes, various electrode arrangement structures, and various number of electrodes may be easily implemented.

FIG. 12 is a cross-sectional view of a metal substrate, a resin layer, electrodes, and thermoelectric legs of the thermoelectric element according to one embodiment of the present invention, and FIGS. 13 and 14 show a top view and a cross-sectional view of the electrodes of the thermoelectric element according to FIG. 12. Overlapping descriptions of the contents the same as FIGS. 8 to 11 will be omitted.

Referring to FIGS. 12 to 14, one pair of the P-type thermoelectric leg 130 and the N-type thermoelectric leg 140 are mounted on the first electrode 120, and to this end, a solder layer S for bonding the first electrode 120 and one pair of the P-type thermoelectric leg 130 and the N-type thermoelectric leg 140 may be further arranged.

The first electrode 120 further includes a second protruding part 124 arranged on the second surface 122.

The second protruding part 124 may be arranged between the P-type thermoelectric leg 130 and the N-type thermoelectric leg 140 on the second surface 122 of the second electrode 120 on which one pair of the P-type thermoelectric leg and the N-type thermoelectric leg are arranged, and the second protruding part 124 may be spaced apart from side surfaces of the P-type thermoelectric leg 130 and the N-type thermoelectric leg 140 by predetermined distances between the P-type thermoelectric leg 130 and the N-type thermoelectric leg 140. Like the above, when the second protruding part 124 is arranged, it is possible to prevent the P-type thermoelectric leg 130 and the N-type thermoelectric leg 140 from tilting or bonding.

In this case, the second protruding part 124 may include a plurality of second protruding parts 124 as shown in FIGS. 13 and 14, may be connected to the first protruding part 123 as shown in FIG. 13, or may be spaced apart from the first protruding part 123 as shown in FIG. 14.

Here, as shown in FIGS. 13 and 14, a groove G may be formed in the second protruding part 124. When the second protruding part 124 is also formed by mechanical cutting or laser processing like the first protruding part 123, a mountain-shaped concave portion and protruding part may be formed around a region to which the laser is applied during the processing. In this case, since the first electrode 120 arranged between the P-type thermoelectric leg 130 and the N-type thermoelectric leg 140 may not be completely cut, output of the laser applied to form the second protruding part 124 may be weaker than output of the laser applied to form the first protruding part 123. Accordingly, a height of the highest point of the second protruding part 124 may be lower than a height of the highest point of the first protruding part 123.

Meanwhile, as shown in FIGS. 8 to 10 and FIG. 12, dummy electrodes on which thermoelectric legs are not arranged may be arranged at the outermost side of the plurality of first electrodes 120, and the first protruding parts 123 may be entirely formed on upper surfaces of the dummy electrodes.

FIG. 15 is a cross-sectional view of a thermoelectric element according to yet another embodiment of the present invention. Overlapping descriptions of the contents the same as FIGS. 8 to 14 will be omitted.

Referring to FIG. 15, the first resin layer 110 may be on some side surfaces of the plurality of first electrodes 120 arranged at the outermost side. That is, in FIGS. 8 to 14, the thickness of the first resin layer 110 arranged at the side lower portion of the first surface 121 of the first electrode 120 is described as being smaller than the thickness of the first resin layer 110 arranged under the first surface 121 of the first electrode 120, and even a part of the first resin layer 110 between the neighboring first electrodes 120 is described as being deleted, but a thickness d3 of the first resin layer 110 arranged on some side surfaces of the plurality of first electrodes 120 may be greater than the thickness d2 of the first resin layer 110 arranged under the first surface 121. Like the above, the first electrodes 120 having side surfaces on which the first resin layer 110 is arranged may be the first electrodes 120 arranged at the outside among the plurality of first electrodes 120, and the side surfaces on which the first resin layer 110 is arranged may be side surfaces arranged to face the outside of the thermoelectric element 100 among the side surfaces of the first electrodes 120 which are arranged at the outside among the plurality of first electrodes 120.

This may be obtained by arranging the plate-shaped metal layer on the first resin layer 110 in the uncured or semi-cured state and pressurizing the metal layer to bury a part of a side surface of the metal layer in the first resin layer 110, and then mechanically cutting or laser processing the metal layer into an electrode shape.

Like the above, when the first resin layer 110 is arranged on some side surfaces of the plurality of first electrodes 120, a contact area and bonding strength between the first electrodes 120 and the first resin layer 110 may be increased, and accordingly, it is possible to minimize a problem in that the first electrodes 120 arranged at the edges among the plurality of first electrodes 120 are easily separated from the first resin layer 110 due to thermal expansion.

FIGS. 16 and 17 are photographs taken after forming the electrodes by laser processing in accordance with the embodiment of the present invention, and FIG. 18 is a photograph taken after forming the electrodes by mechanical processing in accordance with the embodiment of the present invention.

Referring to FIGS. 16 and 17, it can be seen that a protruding part is formed at an upper surface edge of the electrode cut by laser processing, and a surrounding portion of the electrode is carbonized.

Specifically, results in which element contents are measured in region A which is a bottom surface between the two neighboring electrodes, region B which is a side surface of the electrode cut by laser processing, region C which is the protruding part formed along the upper surface edge of the electrode, and region D which is a center region of the upper surface of the electrode are shown as in Tables 1 to 4.

[Table 1]

| Element | Wt% | At% |
|---|---|---|
| Al | 56.44 | 44.91 |
| C | 12.15 | 21.73 |
| O | 22.01 | 29.54 |
| Si | 0.88 | 0.67 |

(continued)

| Element | Wt% | At% |
|---|---|---|
| Cu | 8.01 | 2.71 |

[Table 2]

| Element | Wt% | At% |
|---|---|---|
| C | 27.01 | 39.66 |
| O | 36.95 | 40.73 |
| Al | 18.75 | 12.28 |
| Si | 7.25 | 4.55 |
| Cu | 10.00 | 2.78 |

[Table 3]

| Element | Wt% | At% |
|---|---|---|
| C | 59.06 | 65.03 |
| O | 23.58 | 19.49 |
| Cu | 0.9 | 0.19 |

[Table 4]

| Element | Wt% | At% |
|---|---|---|
| Cu | 74.12 | 36.40 |
| C | 20.26 | 52.64 |
| O | 5.62 | 10.96 |

Referring to Table 1, it can be seen that a part of the metal substrate may be exposed between the two neighboring electrodes, as Al, which is a substrate component, is detected in the region A, which is a bottom surface between the two neighboring electrodes, and referring to Tables 1 to 4, it can be seen that some of the metal is carbonized at the cut surface and the protruding part of the electrode. Specifically, referring to Table 3, it can be seen that the carbide of the protruding part includes carbon at 30 wt% or more, and preferably, 50 wt% or more.

Referring to FIG. 18, it can be seen that the protruding part is formed on the upper surface edge of the electrode cut by mechanical processing, and the plated layer on the electrode surface is peeled off, and thus the copper is exposed.

FIG. 19 is a block diagram of a water purifier to which the thermoelectric element, which does which are not falling under the scope of the appended claims and are considered merely as examples suitable for understanding the invention.

A water purifier 1 to which the thermoelectric element according to the embodiment of the present invention is applied includes a raw water supply pipe 12a, a purified water tank inlet pipe 12b, a purified water tank 12, a filter assembly 13, a cooling fan 14, a heat storage tank 15, a cold water supply pipe 15a, and a thermoelectric device 1000.

The raw water supply pipe 12a is a supply pipe which introduces water to be purified into the filter assembly 13 from a water source, the purified water tank inlet pipe 12b is an inlet pipe which introduces the purified water from the filter assembly 13 into the purified water tank 12, and the cold water supply pipe 15a is a supply pipe through which cold water cooled to a predetermined temperature by the thermoelectric device 1000 in the purified water tank 12 is finally supplied to a user.

The purified water tank 12 temporarily accommodates the purified water to store the water purified through the filter assembly 13 and introduced through the purified water tank inlet pipe 12b and supply the water to the outside.

The filter assembly 13 is composed of a precipitation filter 13a, a pre-carbon filter 13b, a membrane filter 13c,

and a post-carbon filter 13d.

That is, the water introduced into the raw water supply pipe 12a may be purified through the filter assembly 13.

The heat storage tank 15 is arranged between the purified water tank 12 and the thermoelectric device 1000 to store cold air generated in the thermoelectric device 1000. The cold air stored in the heat storage tank 15 is applied to the purified water tank 12 to cool the water accommodated in the purified water tank 120.

The heat storage tank 15 may come into surface contact with the purified water tank 12 so that the cold air may be smoothly transferred.

As described above, the thermoelectric device 1000 includes a heat absorbing surface and a heating surface, and has one side which is cooled and the other side which is heated by the movement of electrons on a P-type semiconductor and an N-type semiconductor.

Here, the one side may be the purified water tank 12 side and the other side may be an opposite side of the purified water tank 12.

Further, as described above, the thermoelectric device 1000 has excellent waterproofing and dustproofing performance, and improved heat flow performance, and thus may efficiently cool the purified water tank 12 in the water purifier.

Hereinafter, with reference to FIG. 20, an example in which the thermoelectric element according to the embodiment of the present invention is applied to a refrigerator will be described.

FIG. 20 is a block diagram of a refrigerator to which the thermoelectric element, which are not falling under the scope of the appended claims and are considered merely as examples suitable for understanding the invention.

The refrigerator includes a deep temperature evaporation chamber cover 23 in a deep temperature evaporation chamber, an evaporation chamber partition wall 24, a main evaporator 25, a cooling fan 26, and a thermoelectric device 1000.

The inside of the refrigerator is partitioned into a deep temperature storage chamber and the deep temperature evaporation chamber by the deep temperature evaporation chamber cover 23.

Specifically, an inner space corresponding to the front of the deep temperature evaporation chamber cover 23 may be defined as the deep temperature storage chamber, and an inner space corresponding to the rear of the deep temperature evaporation chamber cover 23 may be defined as the deep temperature evaporation chamber.

A discharge grill 23a and a suction grill 23b may be formed on a front surface of the deep temperature evaporation chamber cover 23.

The evaporation chamber partition wall 24 is installed at a point spaced frontward from a rear wall of an inner cabinet, and partitions a space in which a deep temperature storage system is located and a space in which the main evaporator 25 is located.

The cold air cooled by the main evaporator 25 is supplied to a freezing chamber and then returns to the main evaporator side.

The thermoelectric device 1000 is accommodated in the deep temperature evaporation chamber, and has a structure in which the heat absorbing surface faces a drawer assembly of the deep temperature storage chamber, and the heating surface faces the evaporator. Accordingly, a heat absorbing phenomenon generated by the thermoelectric device 1000 may be used to quickly cool food stored in the drawer assembly to a super low temperature state of minus 50°C or less.

Further, as described above, the thermoelectric device 1000 has excellent waterproofing and dustproofing performance, and improved heat flow performance, and thus may efficiently cool the drawer assembly in the refrigerator.

The thermoelectric element according to the embodiment of the present invention may be applied to a device for power generation, a device for cooling, a device for heating, and the like. Specifically, the thermoelectric element according to the embodiment of the present invention may be mainly applied to an optical communication module, a sensor, a medical device, a measuring device, aerospace industry, a refrigerator, a chiller, an automobile ventilation sheet, a cup holder, a washing machine, a dryer, a wine cellar, a water purifier, a power supply device for a sensor, a thermopile, and the like.

Here, as an example in which the thermoelectric element according to the embodiment of the present invention is applied to a medical device, there is a polymerase chain reaction (PCR) device. The PCR device is a device for amplifying deoxyribonucleic acid (DNA) to determine a nucleotide sequence of DNA, and demands precise temperature control and requires a thermal cycle. To this end, a Peltier-based thermoelectric element may be applied.

As another example in which the thermoelectric element according to the embodiment of the present invention is applied to the medical device, there is a photodetector. Here, the photodetector includes an infrared/ultraviolet ray detector, a charge coupled device (CCD) sensor, an X-ray detector, a thermoelectric thermal reference source (TTRS), and the like. The Peltier-based thermoelectric element may be applied for cooling the photodetector. Accordingly, it is possible to prevent a wavelength change, an output decrease, a resolution decrease, or the like due to a temperature increase in the photodetector.

As still another example in which the thermoelectric element according to the embodiment of the present

invention is applied to the medical device, there is an immunoassay field, an in vitro diagnostics field, a general temperature control and cooling system, a physical therapy field, a liquid chiller system, a blood/plasma temperature control field, or the like. Accordingly, precise temperature control is possible.

As yet another example in which the thermoelectric element according to the embodiment of the present invention is applied to the medical device, there is an artificial heart. Accordingly, power may be supplied to the artificial heart.

As an example in which the thermoelectric element according to the embodiment of the present invention is applied to the aerospace industry, there is a star tracking system, a thermal imaging camera, an infrared/ultraviolet detector, a CCD sensor, a Hubble space telescope, a TTRS, or the like. Accordingly, it is possible to maintain a temperature of an image sensor.

As another example in which the thermoelectric element according to the embodiment of the present invention is applied to the aerospace industry, there is a cooling device, a heater, a power generation device, or the like.

In addition, the thermoelectric element according to the embodiment of the present invention may be applied to other industrial fields for power generation, cooling, and heating.

## Claims

1. A thermoelectric element comprising:

   a first metal substrate(170);
   a first resin layer(110) arranged on the first metal substrate(170);
   a first electrode(120) arranged on the first resin layer(110);
   a thermoelectric leg(130, 140) arranged on the first electrode(120);
   a second electrode(150) arranged on the thermoelectric leg(130, 140);
   a second resin layer(160) arranged on the second electrode(150); and
   a second metal substrate(180) arranged on the second resin layer(160),
   **characterized in that** an upper surface of the first resin layer(110) includes a first electrode arrangement surface on which the first electrode is disposed, and a first concave surface disposed around the first electrode arrangement surface and toward the first metal substrate(170),
   wherein a lower surface of the second resin layer(160) includes a second electrode arrangement surface on which the second electrode(150) is disposed, and a second concave surface disposed around the second electrode arrangement surface and toward the second metal substrate(180),
   wherein a partial region of the first concave surface and a partial region of the second concave surface are vertically overlapped.

2. The thermoelectric element of claim 1, wherein the first electrode arrangement surface of the first resin layer(110) includes a first flat surface corresponding to a lower surface of the first electrode(120), the second electrode arrangement surface of the second resin layer(160) includes a second flat surface corresponding to an upper surface of the second electrode(150), a partial region of the first electrode arrangement surface and a partial region of the second electrode arrangement surface are vertically overlapped with each other.

3. The thermoelectric element of claim 1 or claim 2, wherein the first resin layer(110) includes a first region of which an upper surface is the first electrode arrangement surface and a second region of which an upper surface is the first concave surface.

4. The thermoelectric element of claim 3, wherein a thickness of the first region and a minimum thickness of the second region differ from each other.

5. The thermoelectric element of claim 4, wherein the first resin layer(110) further includes a third region which surrounds the second region and has a thickness greater than that of the first region and that of the second region.

6. The thermoelectric element of claim 5, wherein the thickness of the first region is greater than the thickness of the second region.

7. The thermoelectric element of claim 1 or claim 2, wherein the second resin layer(160) includes a third region of which a lower surface is the second electrode arrangement surface and a fourth region of which a lower surface is the second concave surface.

8. The thermoelectric element of claim 7, wherein a thickness of the third region and a minimum thickness of the fourth region differ from each other.

9. The thermoelectric element of claim 1, wherein an upper surface of the first electrode(120) includes a flat surface on which the thermoelectric leg(130, 140) is disposed and a first protruding surface disposed around the flat surface.

10. The thermoelectric element of claim 9, wherein the first protruding surface includes a carbide.

11. The thermoelectric element of claim 10, wherein the first protruding surface is continuously arranged around the flat surface of the first electrode(1 10).

12. The thermoelectric element of claim 1, wherein at least one of the first resin layer(110) and the second resin layer(160) has a thickness of 0.02mm or more.

13. The thermoelectric element of claim 12, wherein the least one of the first resin layer(110) and the second resin layer(160) has the thickness of 0.6mm or less.

## Patentansprüche

1. Thermoelektrisches Element umfassend:

   ein erstes Metallsubstrat (170);
   eine erste Harzschicht (110), die an dem ersten Metallsubstrat (170) angeordnet ist;
   eine erste Elektrode (120), die an der ersten Harzschicht (110) angeordnet ist;
   einen thermoelektrischen Schenkel (130, 140), der an der ersten Elektrode (120) angeordnet ist;
   eine zweite Elektrode (150), die an dem thermoelektrischen Schenkel (130, 140) angeordnet ist;
   eine zweite Harzschicht (160), die an der zweiten Elektrode (150) angeordnet ist; und
   ein zweites Metallsubstrat (180), das an der zweiten Harzschicht (160) angeordnet ist, **dadurch gekennzeichnet, dass** eine obere Oberfläche der ersten Harzschicht (110) eine erste Elektrodenanordnungsoberfläche, an der die erste Elektrode angeordnet ist, und eine erste konkave Oberfläche umfasst, die um die erste Elektrodenanordnungsoberfläche herum und zu dem ersten Metallsubstrat (170) hin angeordnet ist,
   wobei eine untere Oberfläche der zweiten Harzschicht (160) eine zweite Elektrodenanordnungsoberfläche, an der die zweite Elektrode (150) angeordnet ist, und eine zweite konkave Oberfläche umfasst, die um die zweite Elektrodenanordnungsoberfläche herum und zu dem zweiten Metallsubstrat (180) hin angeordnet ist,
   wobei eine Teilregion der ersten konkaven Oberfläche und eine Teilregion der zweiten konkaven Oberfläche vertikal überlappt sind.

2. Thermoelektrisches Element nach Anspruch 1, wobei die erste Elektrodenanordnungsoberfläche der ersten Harzschicht (110) eine erste flache Oberfläche umfasst, die einer unteren Oberfläche der ersten Elektrode (120) entspricht, die zweite Elektrodenanordnungsoberfläche der zweiten Harzschicht (160) eine zweite flache Oberfläche umfasst, die einer oberen Oberfläche der zweiten Elektrode (150) entspricht, und eine Teilregion der ersten Elektrodenanordnungsoberfläche und eine Teilregion der zweiten Elektrodenanordnungsoberfläche vertikal miteinander überlappt sind.

3. Thermoelektrisches Element nach Anspruch 1 oder Anspruch 2, wobei die erste Harzschicht (110) eine erste Region, von der eine obere Oberfläche die erste Elektrodenanordnungsoberfläche ist, und eine zweite Region umfasst, von der eine obere Oberfläche die erste konkave Oberfläche ist.

4. Thermoelektrisches Element nach Anspruch 3, wobei eine Dicke der ersten Region und eine Minimaldicke der zweiten Region sich voneinander unterscheiden.

5. Thermoelektrisches Element nach Anspruch 4, wobei die erste Harzschicht (110) ferner eine dritte Region umfasst, die die zweite Region umgibt und eine Dicke aufweist, die größer ist als die der ersten Region und die der zweiten Region.

6. Thermoelektrisches Element nach Anspruch 5, wobei die Dicke der ersten Region größer ist als die Dicke der zweiten Region.

7. Thermoelektrisches Element nach Anspruch 1 oder Anspruch 2, wobei die zweite Harzschicht (160) eine dritte Region, von der eine untere Oberfläche die zweite Elektrodenanordnungsoberfläche ist, und eine vierte Region umfasst, von der eine untere Oberfläche die zweite konkave Oberfläche ist.

8. Thermoelektrisches Element nach Anspruch 7, wobei eine Dicke der dritten Region und eine Minimaldicke der vierten Region sich voneinander unterscheiden.

9. Thermoelektrisches Element nach Anspruch 1, wobei eine obere Oberfläche der ersten Elektrode (120) eine flache Oberfläche, an der der thermoelektrische Schenkel (130, 140) angeordnet ist, und eine erste vorstehend Oberfläche umfasst, die um die flache Oberfläche herum angeordnet ist.

10. Thermoelektrisches Element nach Anspruch 9, wobei die erste vorstehende Oberfläche ein Karbid umfasst.

11. Thermoelektrisches Element nach Anspruch 10, wobei die erste vorstehende Oberfläche kontinuierlich um die flache Oberfläche der ersten Elektrode (110) herum angeordnet ist.

12. Thermoelektrisches Element nach Anspruch 1, wobei wenigstens eine von der ersten Harzschicht (110) und der zweiten Harzschicht (160) eine Dicke von 0,02 mm oder mehr aufweist.

13. Thermoelektrisches Element nach Anspruch 12, wobei wenigstens eine von der ersten Harzschicht (110) und der zweiten Harzschicht (160) die Dicke von 0,6 mm oder weniger aufweist.

**Revendications**

1. Un élément thermoélectrique comprenant :

   un premier substrat métallique (170) ;
   une première couche de résine (110) agencée sur le premier substrat métallique (170) ;
   une première électrode (120) agencée sur la première couche de résine (110) ;
   une branche thermoélectrique (130, 140) agencée sur la première électrode (120) ;
   une deuxième électrode (150) agencée sur la branche thermoélectrique (130, 140) ;
   une deuxième couche de résine (160) agencée sur la deuxième électrode (150) ; et
   un deuxième substrat métallique (180) agencé sur la deuxième couche de résine (160),
   **caractérisé en ce qu'** une surface supérieure de la première couche de résine (110) comprend une première surface d'agencement d'électrodes sur laquelle la première électrode est disposée, et une première surface concave disposée autour de la première surface d'agencement d'électrodes et vers le premier substrat métallique (170),
   une surface inférieure de la deuxième couche de résine (160) comprenant une deuxième surface d'agencement d'électrodes sur laquelle la deuxième électrode (150) est disposée, et une deuxième surface concave disposée autour de la deuxième surface d'agencement d'électrodes et vers le deuxième substrat métallique (180),
   une zone partielle de la première surface concave et une zone partielle de la deuxième surface concave étant verticalement en chevauchement.

2. L'élément thermoélectrique selon la revendication 1, dans lequel la première surface d'agencement d'électrodes de la première couche de résine (110) comprend une première surface plate correspondant à une surface inférieure de la première électrode (120), la deuxième surface d'agencement d'électrodes de la deuxième couche de résine (160) comprend une deuxième surface plate correspondant à une surface supérieure de la deuxième électrode (150), une zone partielle de la première surface d'agencement d'électrodes et une zone partielle de la deuxième surface d'agencement d'électrodes étant verticalement en chevauchement.

3. L'élément thermoélectrique selon la revendication 1 ou la revendication 2, dans lequel la première couche de résine (110) comprend une première zone dont une surface supérieure est la première surface d'agencement d'électrodes et une deuxième zone dont une surface supérieure est la première surface concave.

4. L'élément thermoélectrique selon la revendication 3, dans lequel une épaisseur de la première zone et une épaisseur minimale de la deuxième zone diffèrent l'une de l'autre.

5. L'élément thermoélectrique selon la revendication 4, dans lequel la première couche de résine (110) comprend en outre une troisième zone qui entoure la deuxième zone et a une épaisseur supérieure à celle de la première zone et à celle de la deuxième zone.

6. L'élément thermoélectrique selon la revendication 5, dans lequel l'épaisseur de la première zone est supérieure à l'épaisseur de la deuxième zone.

7. L'élément thermoélectrique selon la revendication 1 ou la revendication 2, dans lequel la deuxième couche de résine (160) comprend une troisième zone dont une surface inférieure est la deuxième surface d'agencement d'électrodes et une quatrième zone dont une surface inférieure est la deuxième surface concave.

8. L'élément thermoélectrique selon la revendication 7, dans lequel une épaisseur de la troisième zone et une épaisseur minimale de la quatrième zone diffèrent l'une de l'autre.

9. L'élément thermoélectrique selon la revendication 1, dans lequel une surface supérieure de la première électrode (120) comprend une surface plate sur laquelle la branche thermoélectrique (130, 140) est disposée et une première surface saillante disposée autour de la surface plate.

10. L'élément thermoélectrique selon la revendication 9, dans lequel la première surface saillante comprend un carbure.

11. L'élément thermoélectrique selon la revendication 10, dans lequel la première surface en saillie est agencée en continu autour de la surface plane de la première électrode (110).

12. L'élément thermoélectrique selon la revendication 1, dans lequel au moins l'une parmi la première couche de résine (110) et la deuxième couche de résine (160) a une épaisseur de 0,02 mm ou plus.

13. L'élément thermoélectrique selon la revendication 12, dans lequel au moins une parmi la première couche de résine (110) et la deuxième couche de résine (160) a une épaisseur de 0,6 mm ou moins.

[FIG. 1]

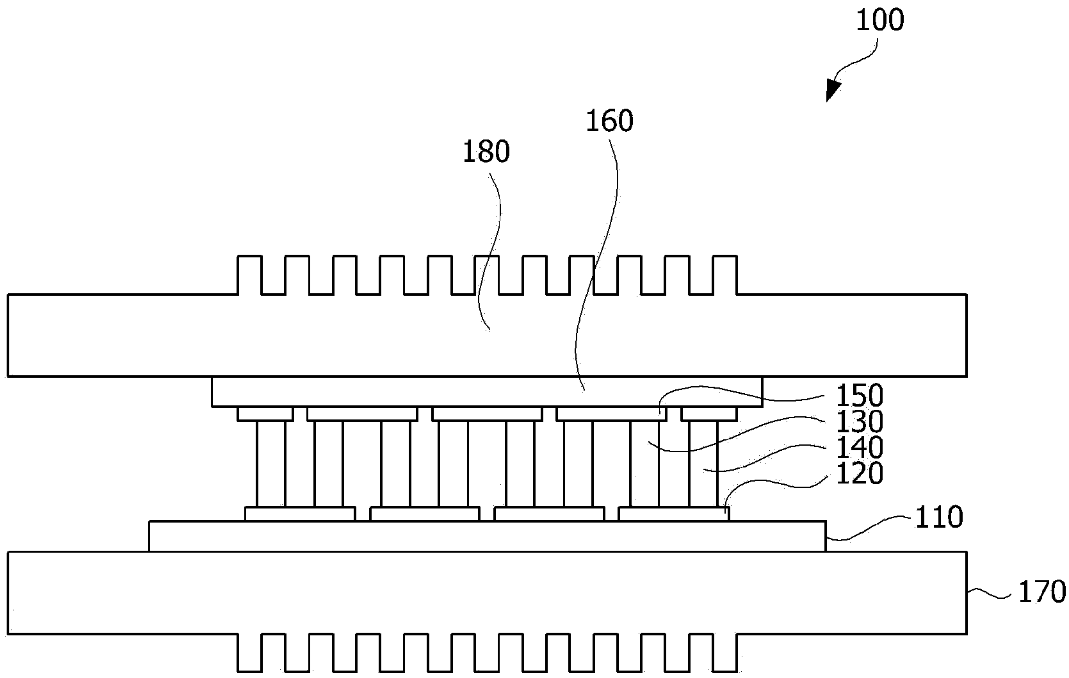

[FIG. 2]

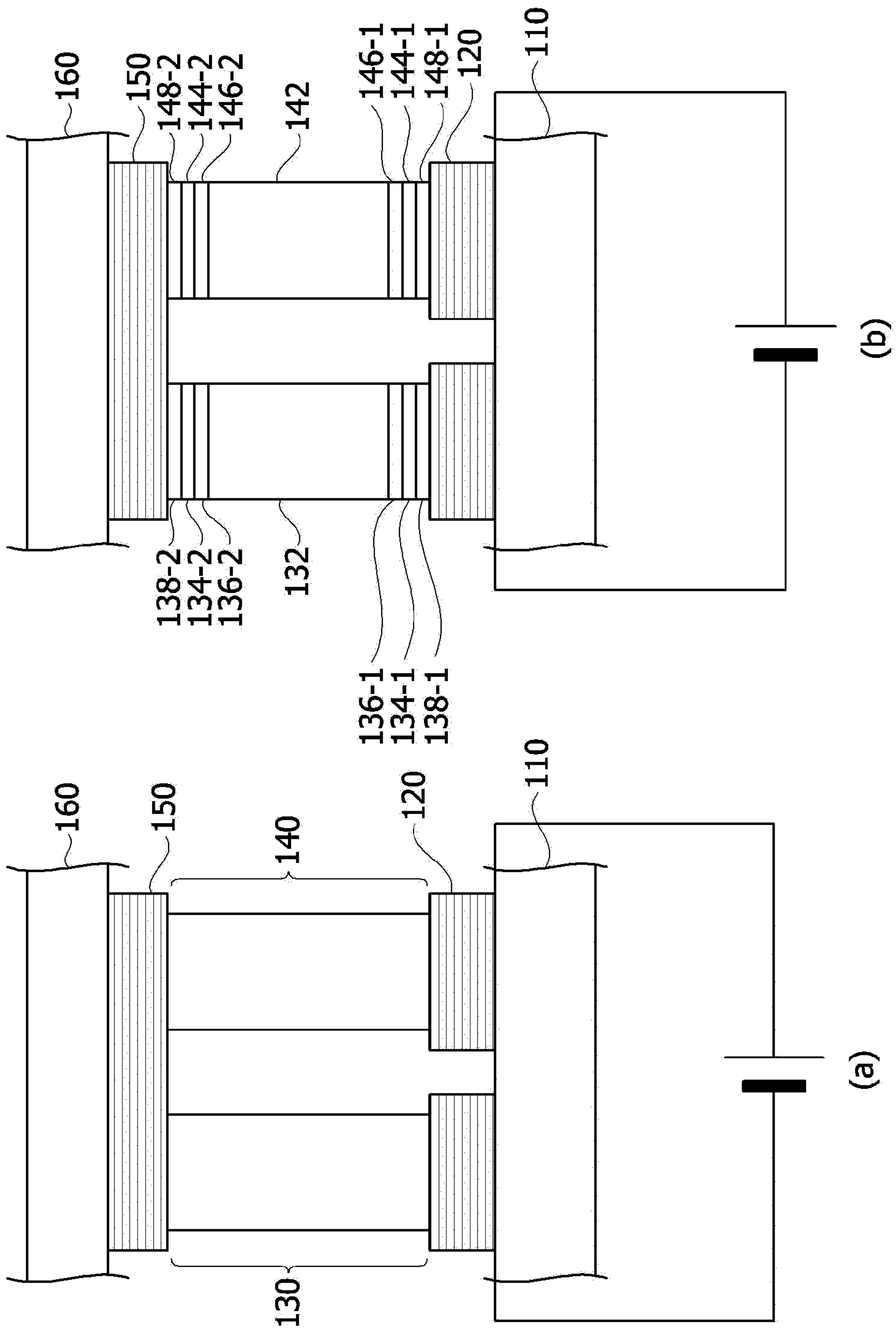
160
150
148-2
144-2
146-2
142
146-1
144-1
148-1
120
110
138-2
134-2
136-2
132
136-1
134-1
138-1
(b)
160
150
140
120
110
130
(a)

[FIG. 3]

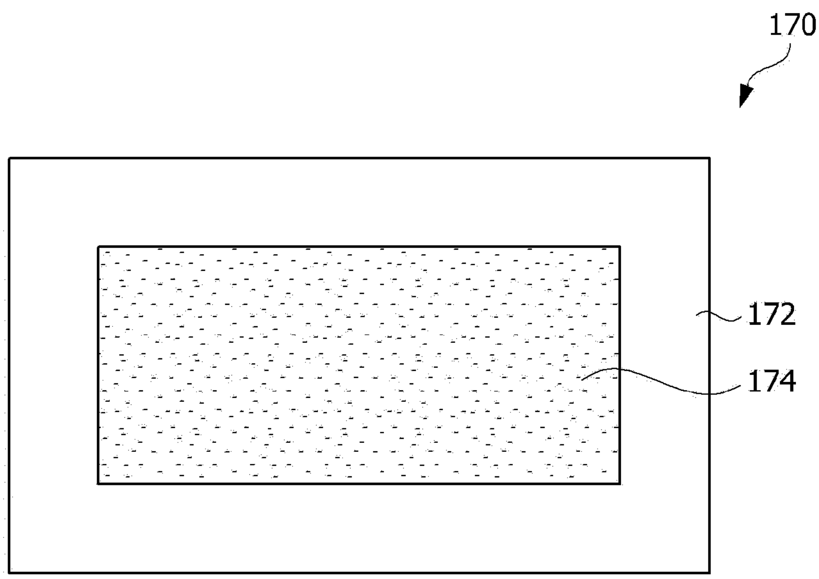


[FIG. 4]

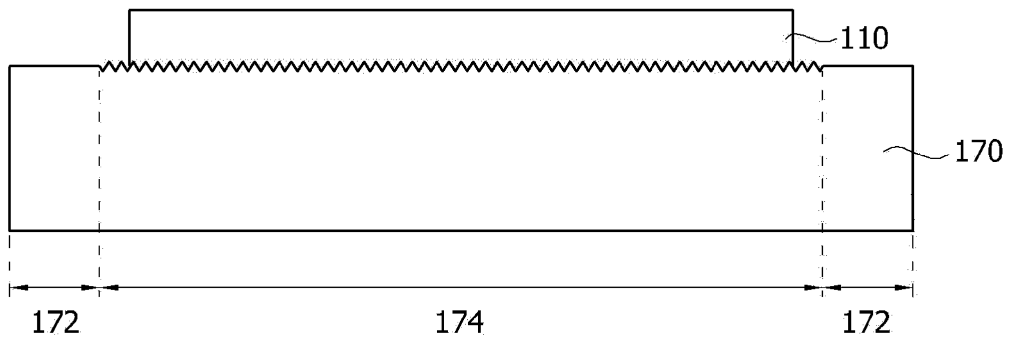

[FIG. 5]

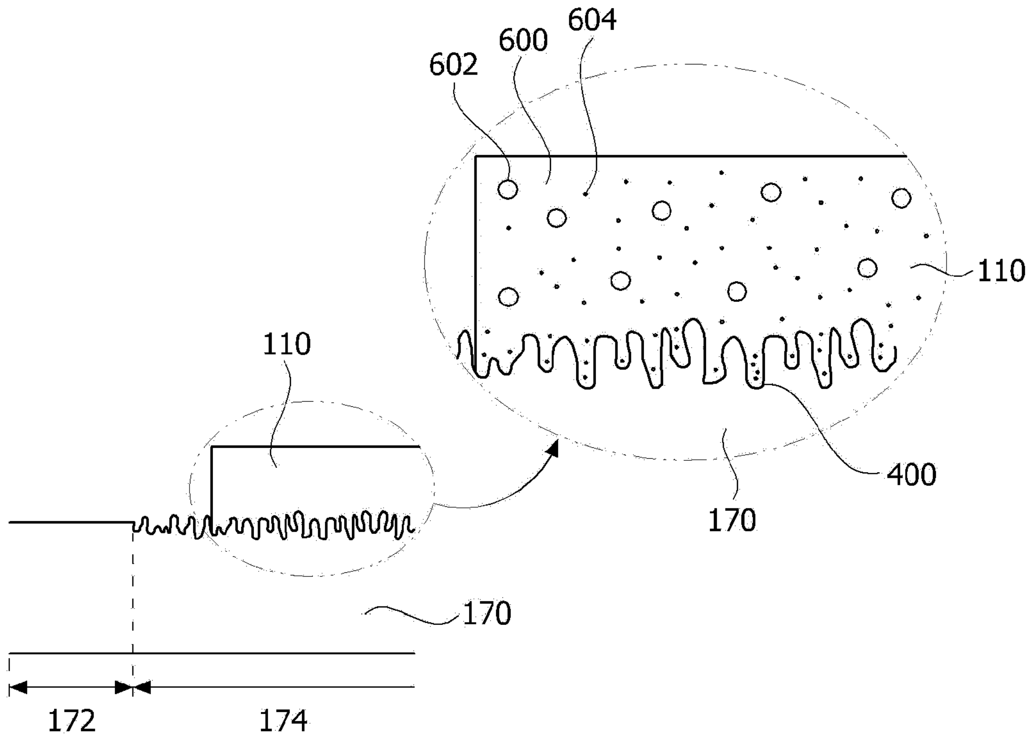


[FIG. 6]

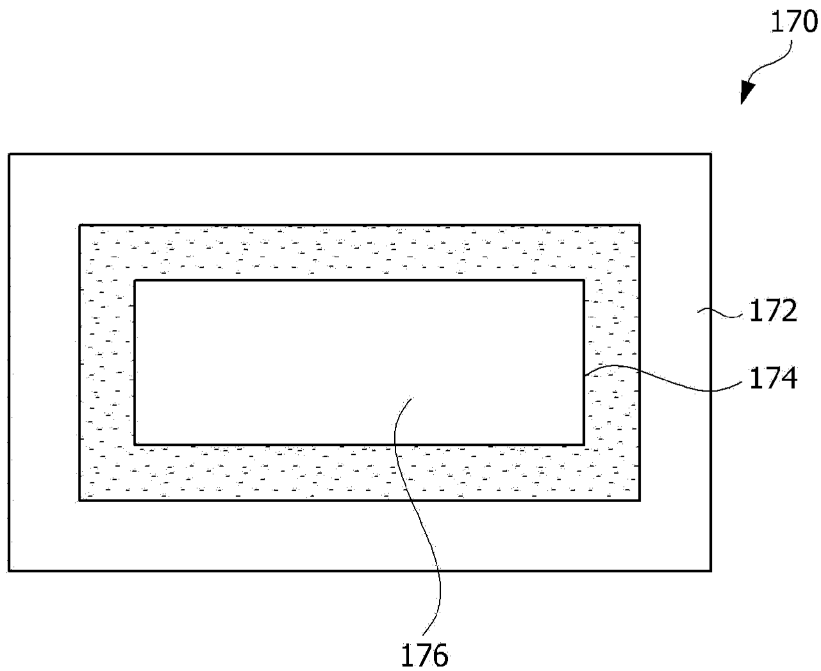

[FIG. 7]

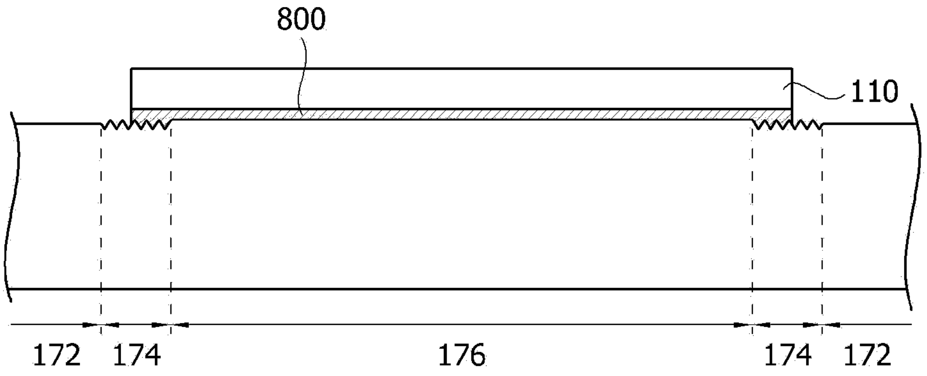
800
110
172
174
176
174
172

[FIG. 8]

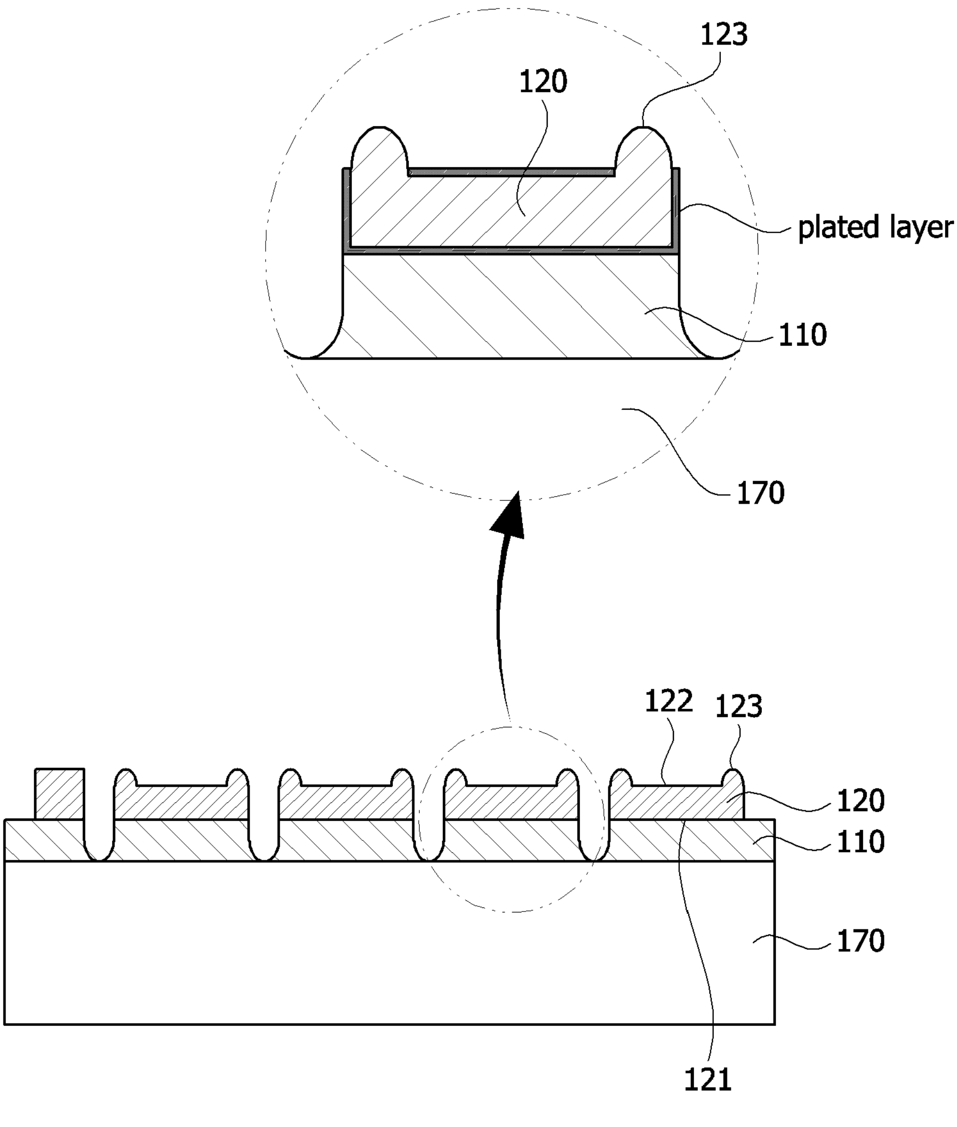
123
120
plated layer
110
170
122
123
120
110
170
121

[FIG. 9]

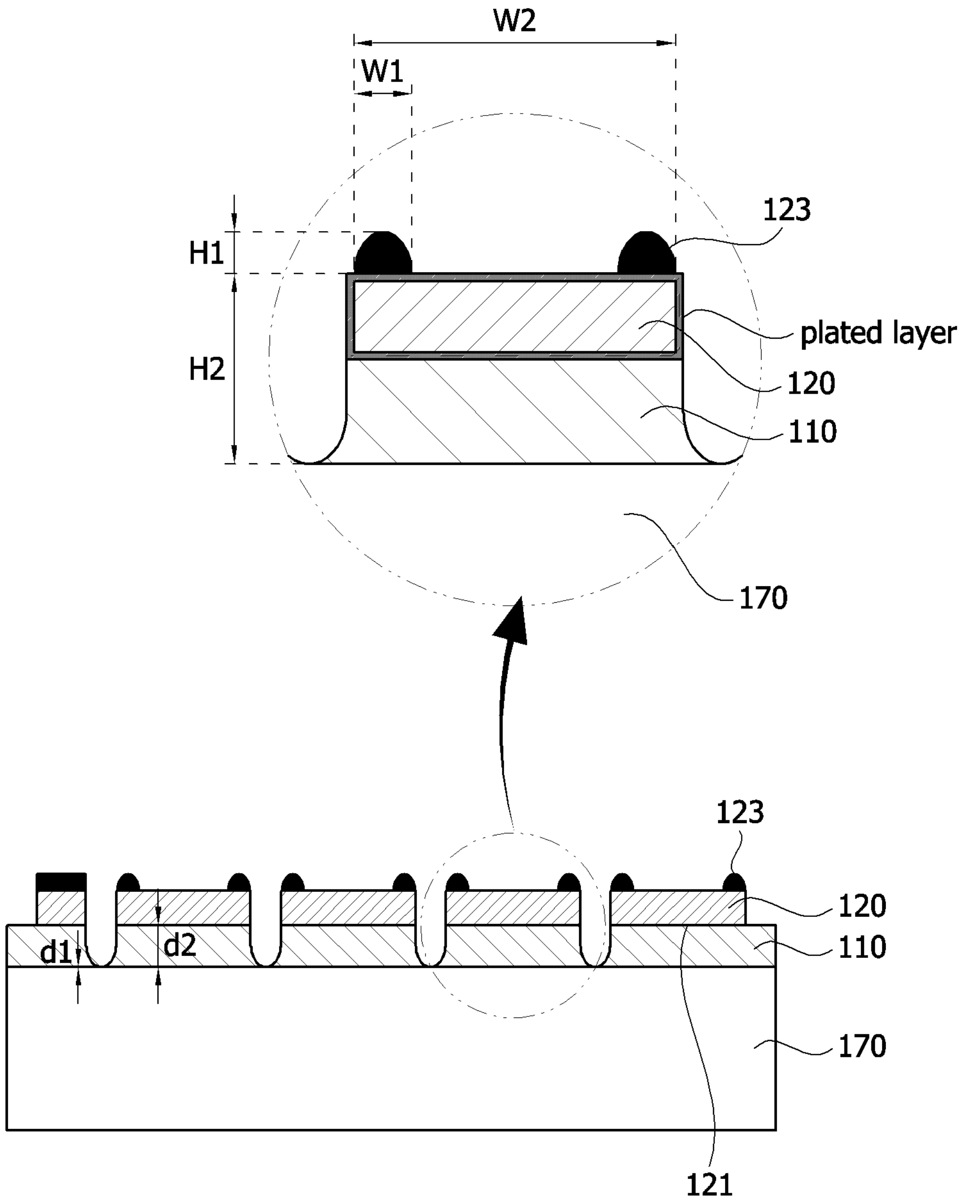
W2
W1
H1
H2
123
plated layer
120
110
170
123
120
d1
d2
110
170
121

[FIG. 10]

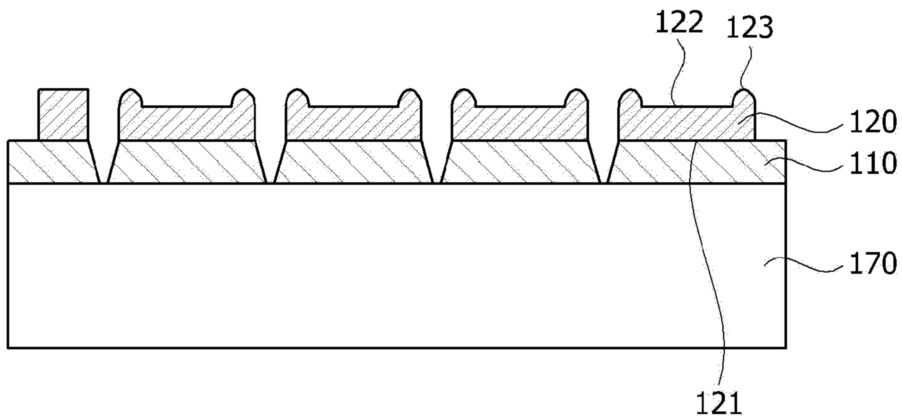

[FIG. 11]

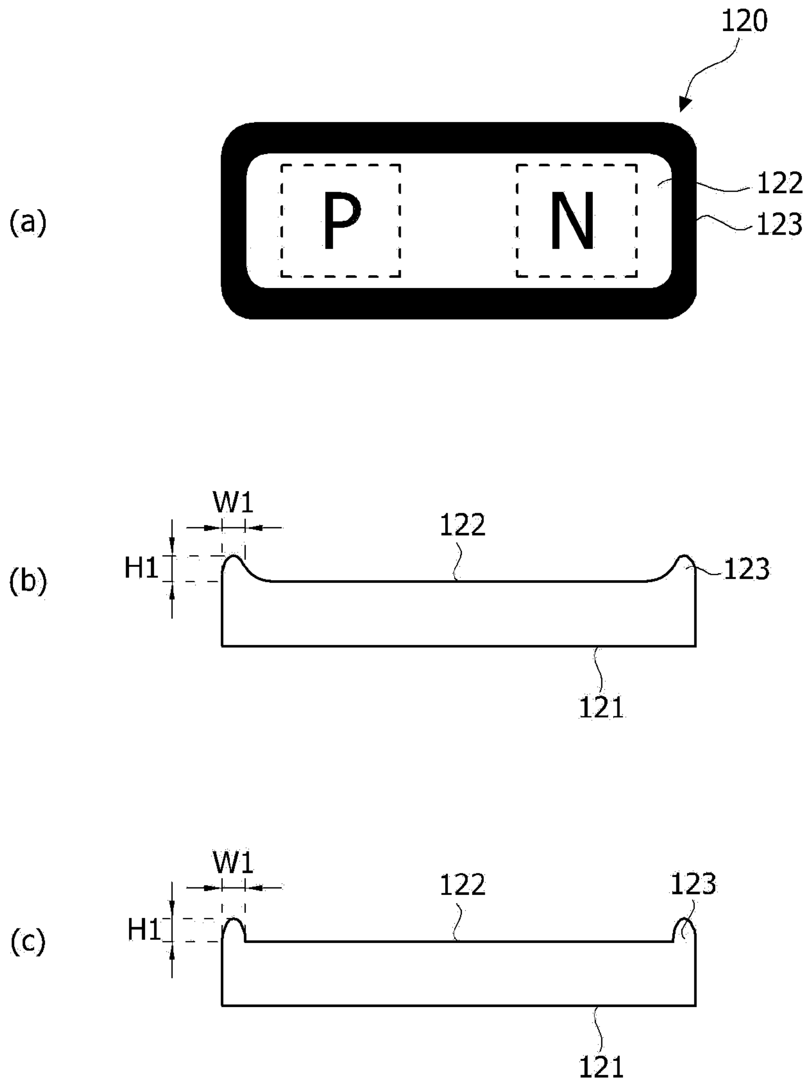

[FIG. 12]

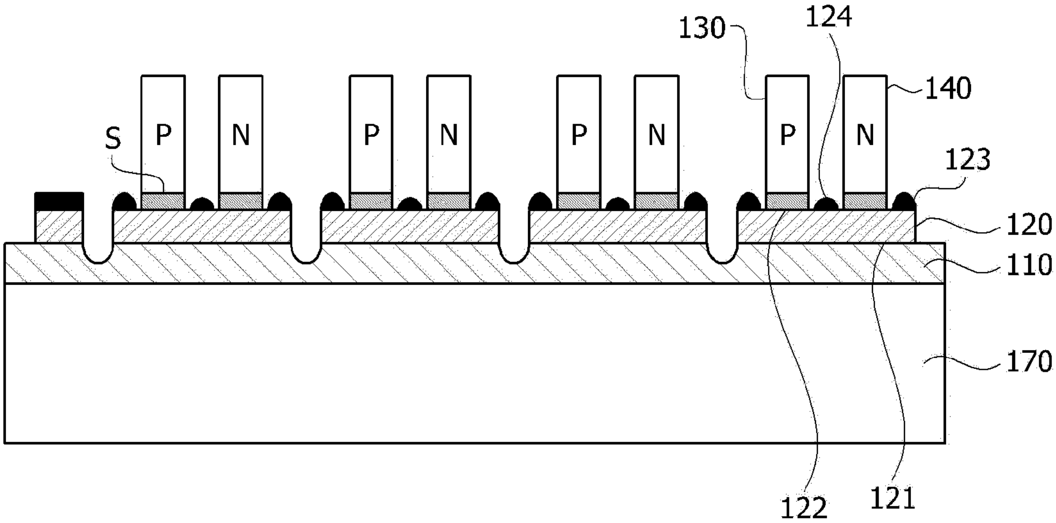


[FIG. 13]

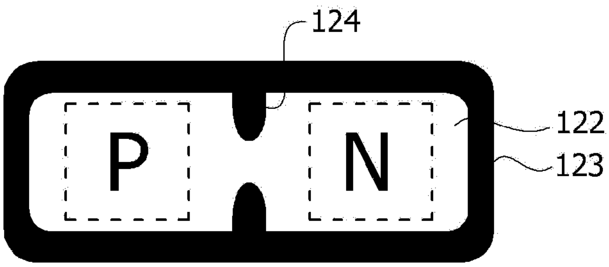

[FIG. 14]

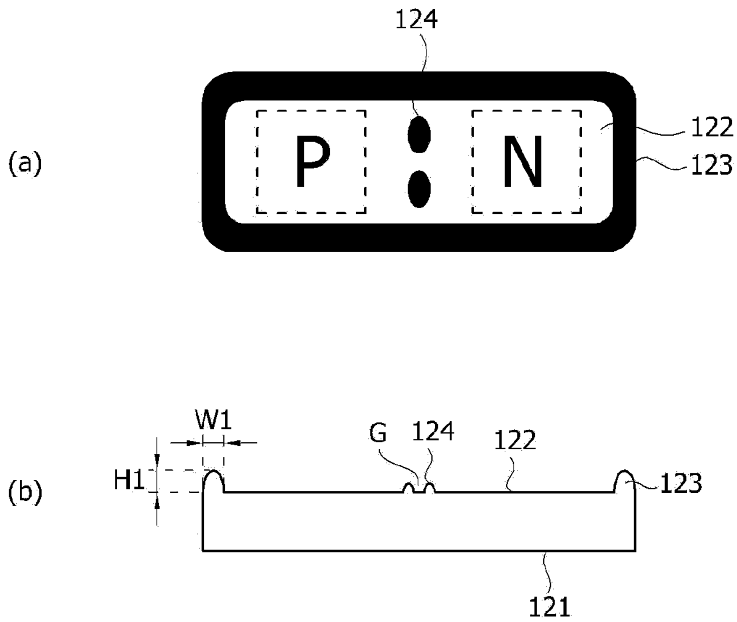
124
(a)
P
N
122
123
(b)
W1
H1
G
124
122
123
121

[FIG. 15]

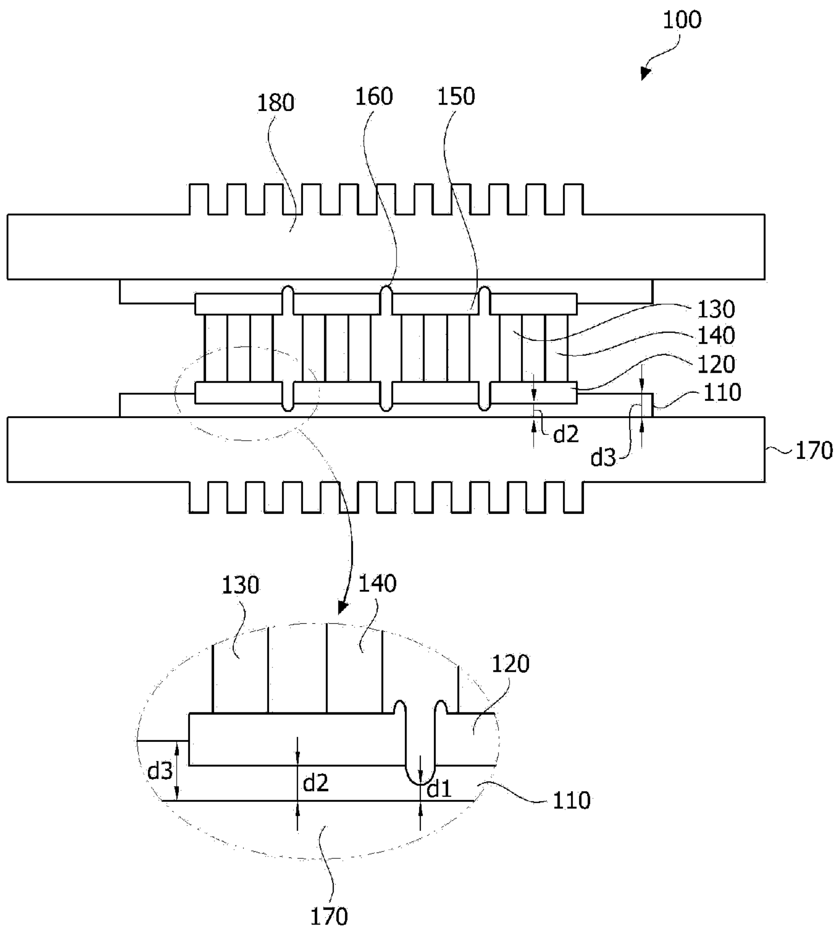
100
180
160
150
130
140
120
110
d2
d3
170
130
140
120
d3
d2
d1
110
170

[FIG. 16]

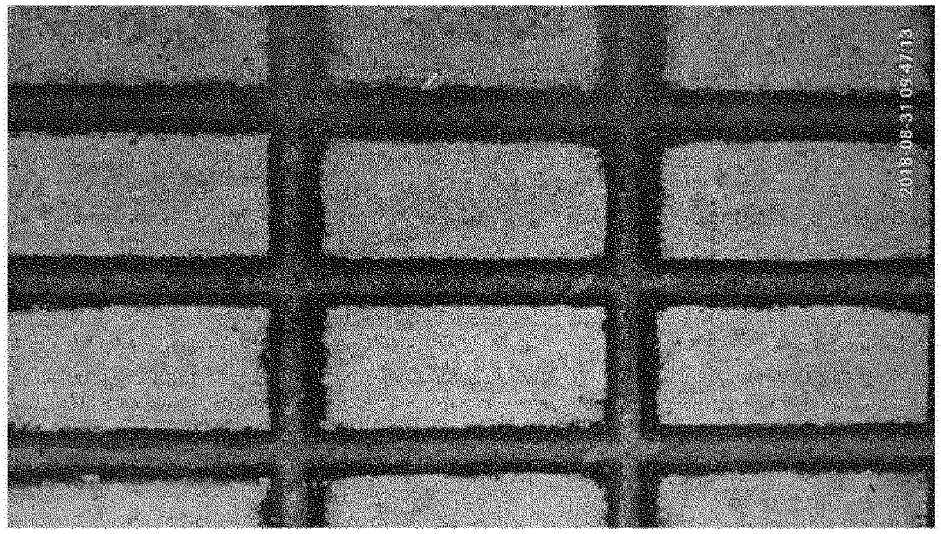

[FIG. 17]

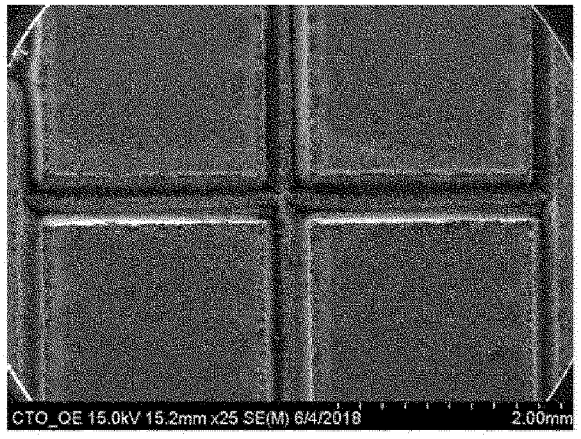
CTO_OE 15.0kV 15.2mm x25 SE(M) 6/4/2018
2.00mm

(a)

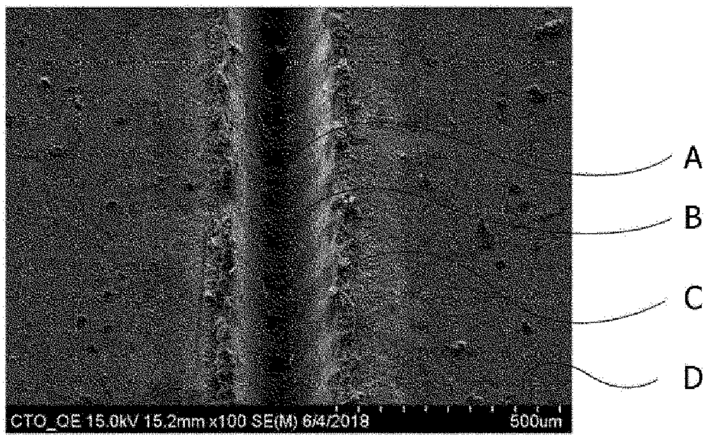
CTO_OE 15.0kV 15.2mm x100 SE(M) 6/4/2018
500um
A
B
C
D

(b)

[FIG. 18]

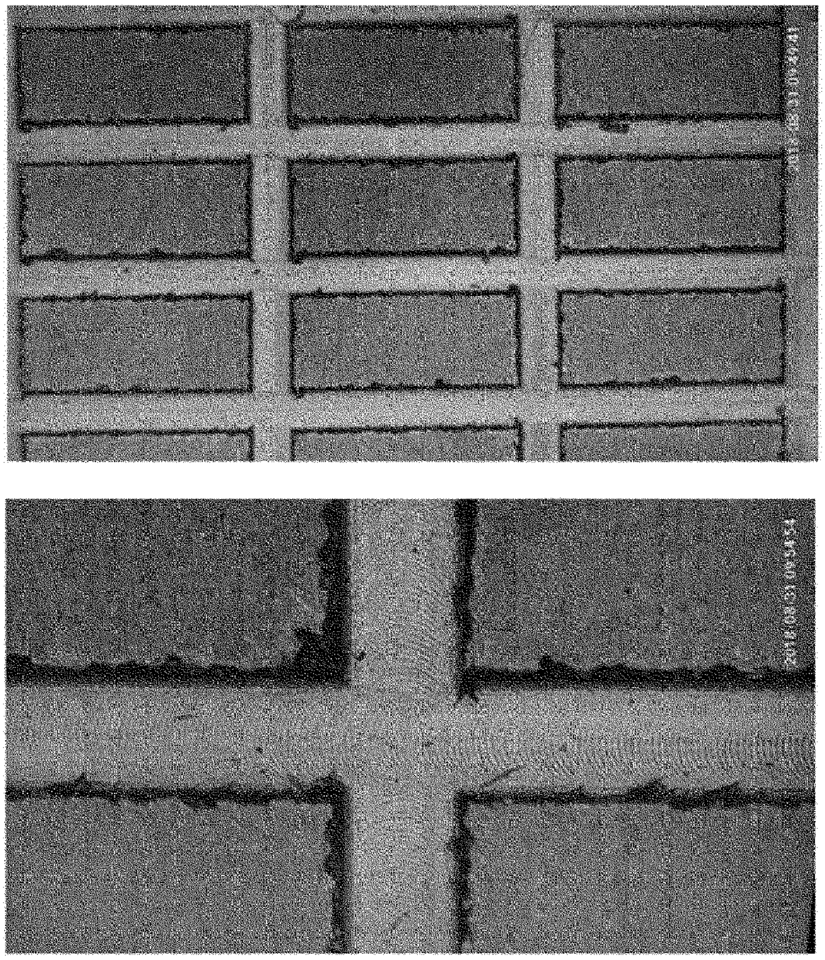

(a)

(b)

[FIG. 19]

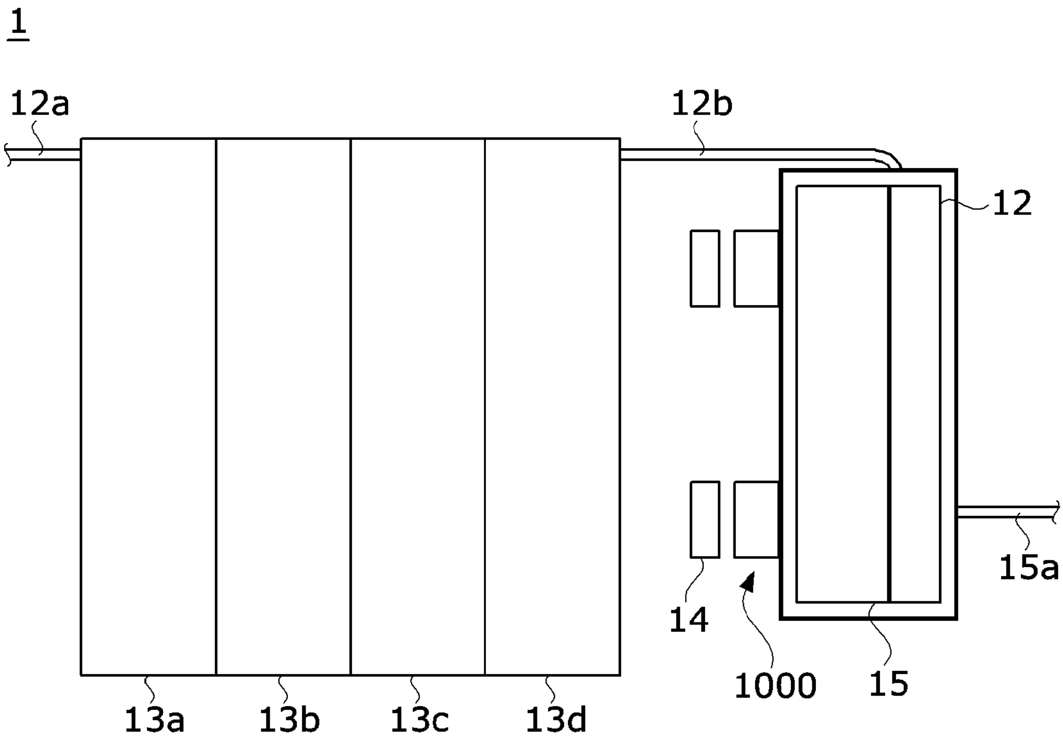
1
12a
12b
12
14
1000
15
15a
13a
13b
13c
13d

[FIG. 20]

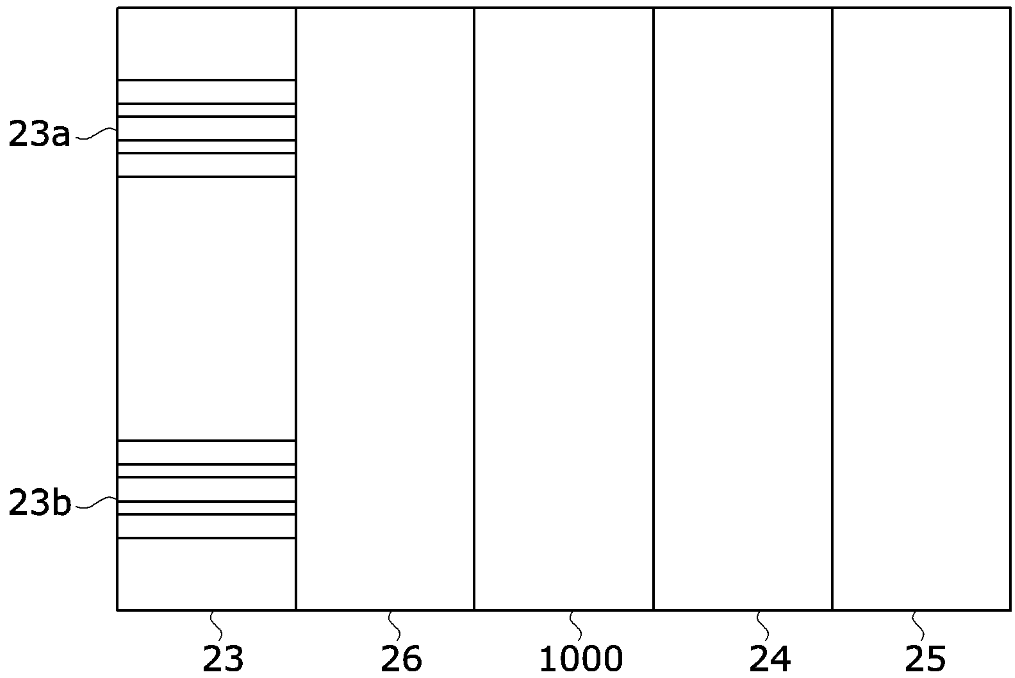
23a
23b
23
26
1000
24
25

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 2013081663 A1
- US 2010096357 A1
- KR 20160126804 A
- KR 20160126805 A